# EUROPEAN PATENT SPECIFICATION

(11) **EP 4 535 422 B1**
(45) Date of publication and mention of the grant of the patent: **04.11.2026**
(21) Application number: 24178163.2
(22) Date of filing: 27.05.2024
(51) Int. Cl.: H10W 20/20

(54) **SEMICONDUCTOR DEVICES**
HALBLEITERANORDNUNGEN
DISPOSITIFS SEMI-CONDUCTEURS

(30) Priority: 06.10.2023 KR 20230133537
(43) Date of publication of application: 09.04.2025
(73) Proprietor: Samsung Electronics Co., Ltd., Suwon-si, Gyeonggi-do 16677 (KR)
(72) Inventor: LEE, Eui Bok, 16677 Suwon-si, Gyeonggi-do (KR); KIM, Rakhwan, 16677 Suwon-si, Gyeonggi-do (KR)
(74) Representative: Kuhnen & Wacker Patent- und Rechtsanwaltsbüro PartG mbB

(56) References cited:
- US-A1- 2018 076 133
- US-A1- 2018 197 815
- US-A1- 2023 022 545
- US-A1- 2023 223 334

## Description

### BACKGROUND OF THE INVENTION

The present disclosure relates to semiconductor devices, and in particular, to semiconductor devices including a conductive structure.

A semiconductor device may include an integrated circuit, including metal-oxide-semiconductor field-effect transistors (MOSFETs). To meet an increasing demand for semiconductor devices with a small pattern size and a reduced design rule, the MOSFETs are being scaled down. The scale-down of the MOSFETs may lead to deterioration in operational properties of semiconductor devices. A variety of studies are being conducted to overcome technical limitations associated with the scale-down of semiconductor devices and to realize high-performance semiconductor devices.

US 2018/076133 A1 discloses methods of forming an interconnect structure including depositing a first conductive material on a substrate, subtractively etching the conductive material to form a patterned first conductive layer, depositing a dielectric layer on interconnect structure, depositing a second conductive material on the dielectric layer, and removing the second conductive material through the top of the second metal liner.

US 2023/223334 A1 discloses an interconnect structure including a lower metal, a dielectric layer, an upper metal, and a graphene layer. The dielectric layer laterally surrounds the lower metal. The upper metal is over the lower metal. The graphene layer is over a top surface of the upper metal and opposite side surfaces of the upper metal from a cross-sectional view.

US 2018/197815 A1 discloses an interconnection structure including an underlying layer including a lower interconnection, and an interlayered dielectric layer including a contact hole and a trench therein. The contact hole exposes a portion of the lower interconnection, and the trench extends along a first direction to be connected to the contact hole. A contact plug extends through the contact hole in the interlayered dielectric layer, and an upper interconnection line extends in the trench of the interlayered dielectric layer and connects to the contact plug. The contact plug includes lower and upper sidewalls inclined at first and second angles, respectively, relative to the underlying layer, and the second angle is less than the first angle. Related devices and fabrication methods are also discussed.

US 2023/022545 A1 discloses a semiconductor device including an FEOL layer, which includes a plurality of individual devices, on a substrate, and first, second, and third metal layers sequentially stacked on the FEOL layer. The second metal layer includes an interlayer insulating layer and an interconnection line in the interlayer insulating layer. The interconnection line includes a lower via portion electrically connected to the first metal layer, an upper via portion electrically connected to the third metal layer, and a line portion between the lower via portion and the upper via portion. A line width of an upper portion of the interconnection line gradually decreases in a vertical direction away from the substrate, and a line width of a lower portion of the interconnection line gradually increases in a vertical direction away from the substrate.

### SUMMARY OF THE INVENTION

Some embodiments of the inventive concept may provide semiconductor devices with improved electrical and reliability characteristics.

Embodiments of the inventive concept are set out in the appended claims.

### BRIEF DESCRIPTION OF THE DRAWINGS

FIGS. 1 to 3 are simplified diagrams illustrating logic cells of a semiconductor device, according to some embodiments of the inventive concept.
FIG. 4A is a plan view illustrating a semiconductor device according to some embodiments of the inventive concept.
FIG. 4B is a sectional view taken along a line A1-A1' of FIG. 4A.
FIG. 4C is a sectional view taken along a line B1-B1' of FIG. 4A.
FIG. 4D is an enlarged view illustrating a portion E1 of FIG. 4B.
FIG. 4E is an enlarged view illustrating a portion E2 of FIG. 4C.
FIGS. 5, 6, 7, 8, 9, and 10 are sectional views illustrating a method of fabricating the semiconductor device of FIGS. 4A to 4E.
FIG. 11 is an enlarged sectional view illustrating a semiconductor device according to some embodiments of the inventive concept.
FIG. 12 is an enlarged sectional view illustrating a semiconductor device according to some embodiments of the inventive concept.
FIG. 13 is an enlarged sectional view illustrating a semiconductor device according to some embodiments of the inventive concept.
FIG. 14 is an enlarged sectional view illustrating a semiconductor device according to some embodiments of the inventive concept.
FIG. 15 is an enlarged sectional view illustrating a semiconductor device according to some embodiments of the inventive concept.
FIG. 16 is a sectional view illustrating a semiconductor device according to some embodiments of the inventive concept.

### DETAILED DESCRIPTION

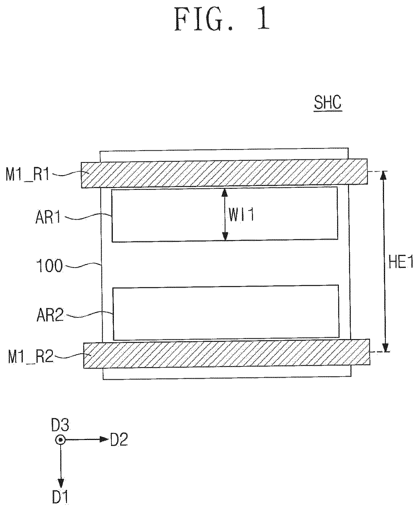

FIGS. 1 to 3 are simplified diagrams illustrating logic cells of a semiconductor device, according to some embodiments of the inventive concept.

Referring to FIG. 1, a single height cell SHC may be provided. A first power line M1_R1 and a second power line M1_R2 may be provided on a substrate 100. The first power line M1_R1 may be a conduction path, to which a source voltage VSS is provided. In some embodiments, the first power line M1_R1 may be a conduction path, to which a ground voltage is provided. The second power line M1_R2 may be a conduction path, to which the drain voltage VDD is provided. In some embodiments, the second power line M1_R2 may be a conduction path, to which a power voltage is provided.

The single height cell SHC may be defined between (a portion (a central portion in a first direction D1) of) the first power line M1_R1 and (a portion (a central portion in the first direction D1) of) the second power line M1_R2. The single height cell SHC may include one first active region AR1 and one second active region AR2. One of the first and second active regions AR1 and AR2 may be a PMOSFET region, and the other of the first and second active regions AR1 and AR2 may be an NMOSFET region. The single height cell SHC may have a CMOS structure provided between (a portion (a central portion in the first direction D1) of) the first power line M1_R1 and (a portion (a central portion in the first direction D1) of) the second power line M1_R2.

Each of the first and second active regions AR1 and AR2 may have a first width WI1 in the first direction D1. A length of the single height cell SHC in the first direction D1 may be defined as a first height HE1. The first height HE1 may be (substantially) equal to a distance (e.g., a pitch) between (a portion (a central portion in the first direction D1) of) the first power line M1_R1 and (a portion (a central portion in the first direction D1) of) the second power line M1_R2.

The single height cell SHC may constitute a single logic cell. In the present specification, the logic cell may mean a logic device (e.g., AND, OR, XOR, XNOR, inverter, and so forth), which is configured to execute a specific function. The logic cell may include transistors constituting the logic device and interconnection lines connecting (e.g., electrically connecting) the transistors to each other. It will be understood that when an element or layer is referred to as being "connected to", or "coupled to", another element or layer, it may be directly on, connected to, or coupled to the other element or layer, or one or more intervening elements or layers may be present. In contrast, when an element is referred to as being "directly coupled," "directly connected," or "directly responsive" to, or "directly on," another element, there are no intervening elements present. In addition, "electrical connection" conceptually includes a physical connection and a physical disconnection.

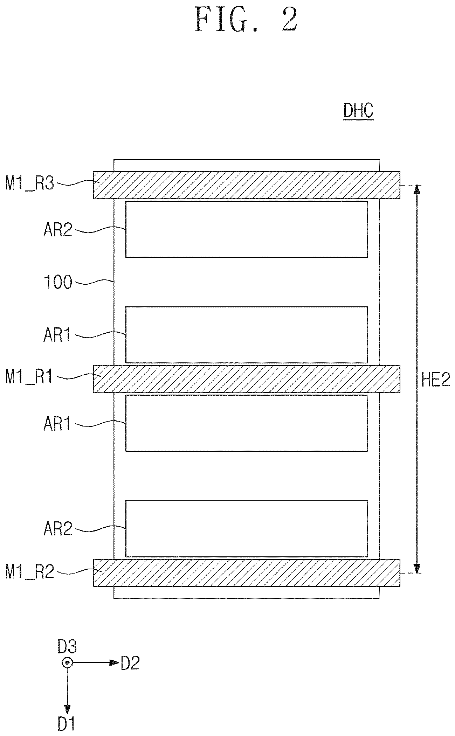

Referring to FIG. 2, a double height cell DHC may be provided. In detail, a first power line M1_R1, a second power line M1_R2, and a third power line M1_R3 may be provided on the substrate 100. The first power line M1_R1 may be disposed between the second power line M1_R2 and the third power line M1_R3 (in the first direction D1). The third power line M1_R3 may be a conduction path, to which the source voltage VSS is provided.

The double height cell DHC may be defined between (a (central) portion in the first direction D1 of) the second power line M1_R2 and (a (central) portion in the first direction D1 of) the third power line M1_R3. The double height cell DHC may include two first active regions AR1 and two second active regions AR2.

One of the two second active regions AR2 may be adjacent to the second power line M1_R2. The other of the two second active regions AR2 may be adjacent to the third power line M1_R3. The two (or the pair of) first active regions AR1 may be adjacent to the first power line M1_R1. When viewed in a plan view, the first power line M1_R1 may be disposed between the pair of the first active regions AR1 (in the first direction D1).

A length of the double height cell DHC in the first direction D1 may be defined as a second height HE2. The second height HE2 may be about two times the first height HE1 of FIG. 1. The pair of the first active regions AR1 of the double height cell DHC may be combined to serve as a single active region.

The double height cell DHC shown in FIG. 2 may be defined as a multi-height cell. In some embodiments, the multi-height cell may include a triple height cell whose cell height is about three times that of the single height cell SHC.

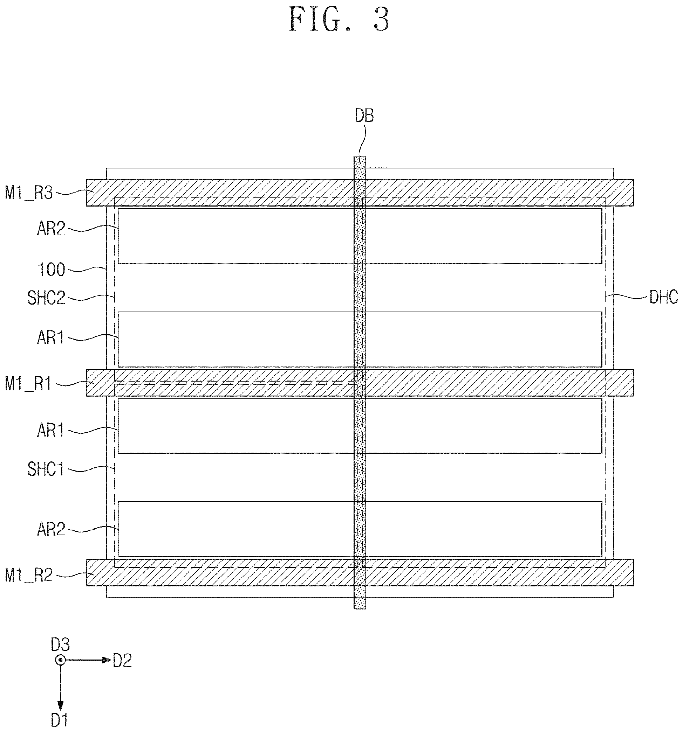

Referring to FIG. 3, a first single height cell SHC1, a second single height cell SHC2, and a double height cell DHC may be two-dimensionally disposed on the substrate 100. The first single height cell SHC1 may be disposed between the first and second power lines M1_R1 and M1_R2. The second single height cell SHC2 may be disposed between the first and third power lines M1_R1 and M1_R3. The second single height cell SHC2 may be adjacent to the first single height cell SHC1 in the first direction D1.

The double height cell DHC may be disposed between the second and third power lines M1_R2 and M1_R3. The double height cell DHC may be adjacent to the first and second single height cells SHC1 and SHC2 in a second direction D2.

A division structure DB may be provided between the first single height cell SHC1 and the double height cell DHC and between the second single height cell SHC2 and the double height cell DHC. The active region (e.g., the first active region AR1 and/or the second active region AR2) of the double height cell DHC may be electrically separated from the active region (e.g., the first active region AR1 and/or the second active region AR2) of each of the first and second single height cells SHC1 and SHC2 by the division structure DB. As used herein, the term "and/or" includes any and all combinations of one or more of the associated listed items. Expressions such as "at least one of," when preceding a list of elements, modify the entire list of elements and do not modify the individual elements of the list.

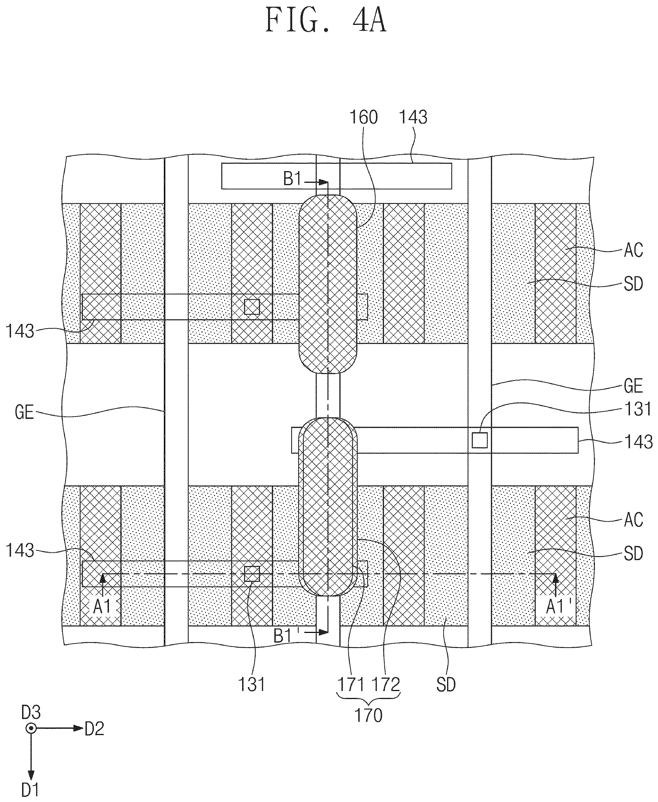

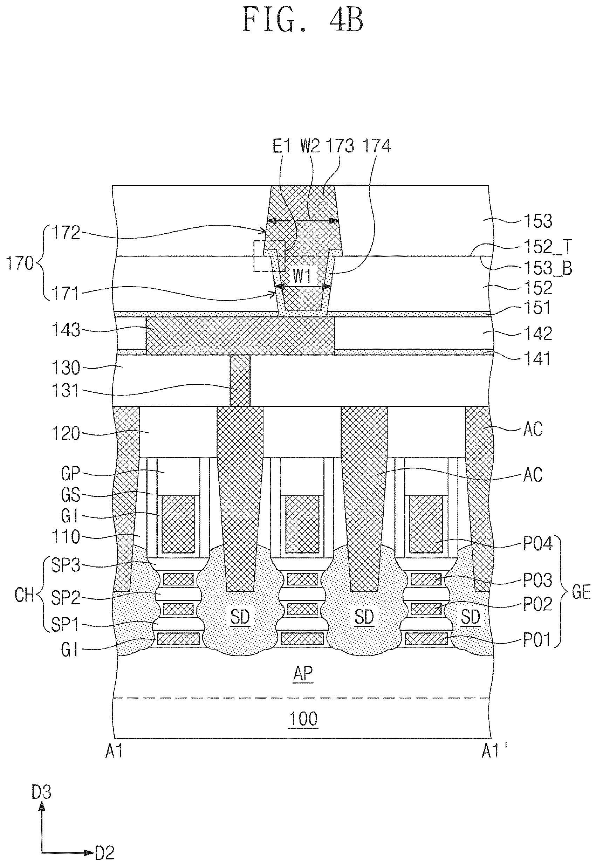

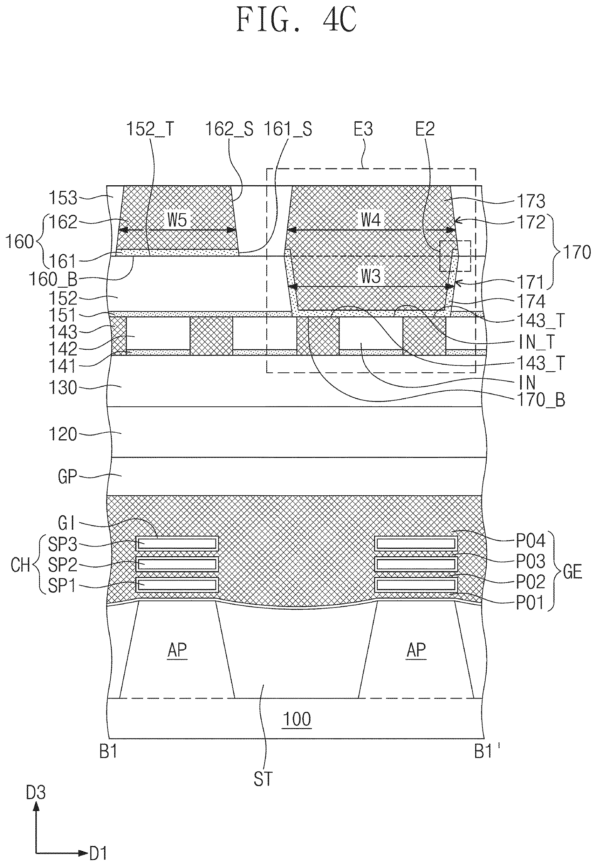

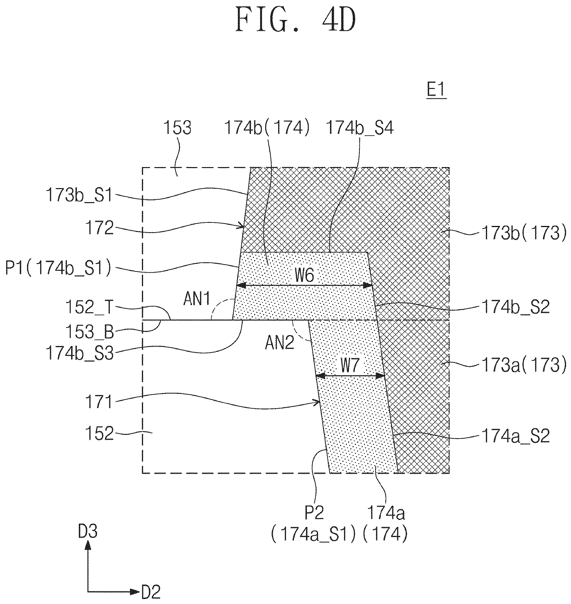

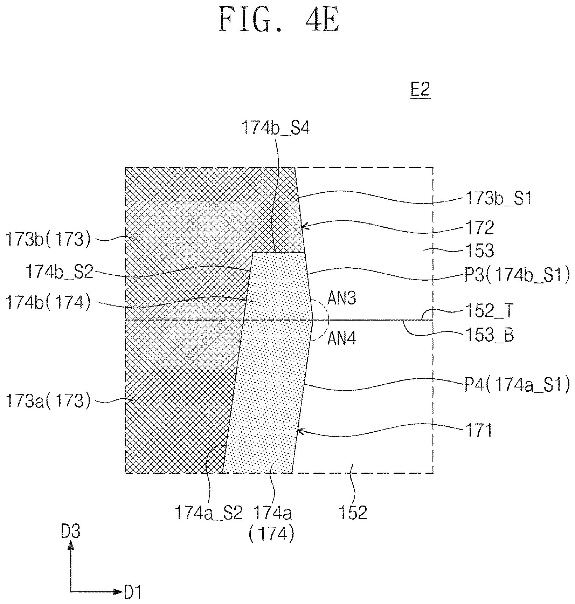

FIG. 4A is a plan view illustrating a semiconductor device according to some embodiments of the inventive concept. FIG. 4B is a sectional view taken along a line A1-A1' of FIG. 4A. FIG. 4C is a sectional view taken along a line B1-B1' of FIG. 4A. FIG. 4D is an enlarged view illustrating a portion E1 of FIG. 4B. FIG. 4E is an enlarged view illustrating a portion E2 of FIG. 4C.

Referring to FIGS. 4A to 4C, the semiconductor device may include the substrate 100. The single height cell SHC may be provided on the substrate 100. A logic cell may be disposed on the single height cell SHC. In some embodiments, the substrate 100 may include (e.g., may be) a semiconductor substrate. As an example, the substrate 100 may be formed of or include silicon, germanium, silicon-germanium, GaP, and/or GaAs. In some embodiments, the substrate 100 may include (e.g., may be) an insulating substrate, a silicon-on-insulator (SOI) substrate, and/or a germanium-on-insulator (GOI) substrate. The substrate 100 may be a plate-shaped structure which is extended in the first and second directions D1 and D2. The first and second directions D1 and D2 may not be parallel to each other. The first and second directions D1 and D2 may be parallel with an upper surface of the substrate 100. The first and second directions D1 and D2 may be horizontal directions that intersect (e.g., that are orthogonal to) each other.

The substrate 100 may include active patterns AP. The active patterns AP may be defined by a trench (which will be at least partially filled with a device isolation layer ST described below) on the substrate 100. For example, the active patterns AP may be adjacent to the trench (or the device isolation layer ST). The active patterns AP may be extended in the second direction D2. The active patterns AP may be portions of the substrate 100 that are formed to protrude in a third direction D3. The third direction may be perpendicular to the upper surface of the substrate 100. The third direction D3 may not be parallel to the first and second directions D1 and D2. The third direction D3 may be a vertical direction that is orthogonal to the first and second directions D1 and D2.

A device isolation layer ST may be provided on the substrate 100. The device isolation layer ST may (at least partially) fill the trench on the substrate 100. The device isolation layer ST may include an insulating material. For example, the device isolation layer ST may be formed of or include at least one of oxide materials.

Source/drain patterns SD may be provided on the active pattern AP. In some embodiments, the source/drain patterns SD may be arranged (e.g., may be spaced apart from each other) on the active pattern AP in the second direction D2.

The source/drain patterns SD may be epitaxial patterns, which are formed by a selective epitaxial growth (SEG) process. The source/drain patterns SD may include a semiconductor material. In some embodiments, the source/drain patterns SD may be formed of or include silicon (Si), silicon-germanium (SiGe), and/or germanium (Ge). In some embodiments, the source/drain pattern SD, which is connected (e.g., electrically connected) to one of the active patterns AP, may be doped with p-type impurities to have a p-type conductivity type, and the source/drain pattern SD, which is connected (e.g., electrically connected) to the other of the active patterns AP, may be doped with n-type impurities to have an n-type conductivity type.

A channel structures CH may be provided. The channel structures CH may be provided between the source/drain patterns SD, which are adjacent to each other. The channel structures CH may be overlapped with the active pattern AP in the third direction D3. The channel structures CH, which are overlapped with each active pattern AP in the third direction D3, may be arranged (e.g., may be spaced apart from each other) in the second direction D2. As used herein, "an element A overlapping an element B in a direction X" (or similar language) means that there is at least one line that extends in the direction X and intersects both the elements A and B.

Each of the channel structures CH may include a first semiconductor pattern SP1, a second semiconductor pattern SP2, and a third semiconductor pattern SP3, which are spaced apart from each other in the third direction D3. The first, second, and third semiconductor patterns SP1, SP2, and SP3 may be overlapped with each other in the third direction D3. The first, second, and third semiconductor patterns SP1, SP2, and SP3 may be formed of or include a semiconductor material. As an example, the first, second, and third semiconductor patterns SP1, SP2, and SP3 may be formed of or include silicon.

The number of the semiconductor patterns SP1, SP2, and SP3 in each channel structure CH is not limited to the illustrated example. In some embodiments, the number of the semiconductor patterns SP1, SP2, and SP3 in each channel structure CH may be less than or equal to two or may be greater than or equal to four.

Gate electrodes GE may be provided to extend in the first direction D1. The gate electrode GE may be provided to cross at least one of the active patterns AP. The gate electrode GE may be provided to cross at least one of the channel structures CH. The gate electrode GE may be overlapped with the channel structure CH in the third direction D3.

The gate electrode GE may include a first electrode portion PO1 between the active pattern AP and the first semiconductor pattern SP1, a second electrode portion PO2 between the first and second semiconductor patterns SP1 and SP2, a third electrode portion PO3 between the second and third semiconductor patterns SP2 and SP3, and a fourth electrode portion PO4 on the third semiconductor pattern SP3. The gate electrode GE may include a conductive material. The gate electrode GE and the first to third semiconductor patterns SP1, SP2, and SP3 may constitute a three-dimensional field effect transistor (e.g., MBCFET or GAAFET). In some embodiment, the channel structure CH may have a single body structure (e.g., a fin structure), not a structure including separated semiconductor patterns.

A pair of gate spacers GS may be respectively disposed at both (e.g., opposite) sides of the gate electrode GE. The gate spacers GS may be extended along the gate electrode GE and in the first direction D1. Upper (e.g., uppermost) surfaces of the gate spacers GS may be higher than an upper (e.g., an uppermost) surface of the gate electrode GE. In some embodiments, the upper (e.g., the uppermost) surfaces of the gate spacers GS may be coplanar with an upper (e.g., an uppermost) surface of a first insulating layer 110, which will be described below. The vertical level may be a relative location (e.g., a distance) from an upper (or a lower) surface of the substrate 100 in a vertical direction (e.g., in the third direction D3). For example, when element A is higher than element B, element A may be located farther than element B from the upper surface of the substrate 100 in the third direction D3.

A gate capping pattern GP may be provided on the gate electrode GE. The gate capping pattern GP may be extended along the gate electrode GE in the first direction D1. The gate capping pattern GP may include an insulating material having an etch selectivity with respect to first and second insulating layers 110 and 120, which will be described below. For example, the gate capping pattern GP may be formed of or include at least one of nitride materials.

A gate insulating layer GI may be provided. The gate insulating layer GI may separate (e.g., electrically separate) the gate electrode GE from the semiconductor patterns SP1, SP2, and SP3. For example, the gate insulating layer GI may be between the gate electrode GE (e.g., the first, second, third, and fourth electrode portions PO1, PO2, PO3, and PO4). The gate insulating layer GI may be in contact with the gate electrode GE (e.g., the first, second, third, and fourth electrode portions PO1, PO2, PO3, and PO4) and the semiconductor patterns SP1, SP2, and SP3. The gate insulating layer GI may include an insulating material. As an example, the gate insulating layer GI may be formed of or include at least one of oxide materials.

The first insulating layer 110 may be provided on the gate spacers GS and the source/drain patterns SD. An upper (e.g., an uppermost) surface of the first insulating layer 110 may be coplanar with an upper (e.g., an uppermost) surface of the gate capping pattern GP and an upper (e.g., an uppermost) surface of the gate spacer GS. A second insulating layer 120 may be provided on the first insulating layer 110 and the gate capping pattern GP. A cover insulating layer 130 may be provided on the second insulating layer 120. The first insulating layer 110, the second insulating layer 120, and the cover insulating layer 130 may include an insulating material. As an example, the first insulating layer 110, the second insulating layer 120, and the cover insulating layer 130 may be formed of or include at least one of oxide materials. In some embodiments, each of the first insulating layer 110, the second insulating layer 120, and the cover insulating layer 130 may have a multi-layered structure including a plurality of insulating layers.

Active contacts AC may be provided to extend in (e.g., extend through or penetrate) the first and second insulating layers 110 and 120. The active contact AC may be electrically connected to the source/drain pattern SD. The gate electrode GE may be provided between the active contacts AC, which are adjacent to each other in the second direction D2. The active contact AC may be a bar-shaped pattern extending in the first direction D1.

In some embodiments, a metal-semiconductor compound layer may be interposed between the active contact AC and the source/drain pattern SD. In this case, the active contact AC may be electrically connected to the source/drain pattern SD through the metal-semiconductor compound layer. For example, the metal-semiconductor compound layer may be formed of or include titanium-silicide, tantalum-silicide, tungsten-silicide, nickel-silicide, and/or cobalt-silicide.

In some embodiments, the active contact AC may include a conductive pattern and a barrier pattern. The barrier pattern may be on (e.g., cover or overlap) side and lower (e.g., lowermost) surfaces of the conductive pattern. For example, the conductive pattern may be formed of or include aluminum, copper, tungsten, molybdenum, and/or cobalt, and the barrier pattern may be formed of or include titanium, tantalum, tungsten, nickel, cobalt, titanium nitride (TiN), tantalum nitride (TaN), tungsten nitride (WN), nickel nitride (NiN), cobalt nitride (CoN), and/or platinum nitride (PtN).

Conductive contacts 131 may be provided to extend in (e.g., extend through or penetrate) the cover insulating layer 130. The conductive contact 131 may electrically connect a first conductive line 143, which will be described below, to the active contact AC or may electrically connect the first conductive line 143 to the gate electrode GE. The conductive contact 131 may include a conductive material.

A first etch stop layer 141 may be provided on the cover insulating layer 130. A first interlayer insulating layer 142 may be provided on the first etch stop layer 141. A second etch stop layer 151 may be provided on the first interlayer insulating layer 142. A second interlayer insulating layer 152 may be provided on the second etch stop layer 151. A third interlayer insulating layer 153 may be provided on the second interlayer insulating layer 152.

The first etch stop layer 141 and the first interlayer insulating layer 142 may include insulating materials having an etch selectivity with respect to each other. As an example, the first etch stop layer 141 may be formed of or include silicon nitride (SiN), silicon carbonitride (SiCN), silicon carbide oxide (SiCO), aluminum nitride (AlN), and/or aluminum oxide (AlO), and the first interlayer insulating layer 142 may be formed of or include low-k dielectric materials, tetraethyl orthosilicate (TEOS), silicon carbide hydroxide (SiCHO), and/or silicon oxide (SiO).

The second etch stop layer 151 and the second interlayer insulating layer 152 may include insulating materials having an etch selectivity with respect to each other. As an example, the second etch stop layer 151 may be formed of or include silicon nitride (SiN), silicon carbonitride (SiCN), silicon carbide oxide (SiCO), aluminum nitride (AlN), and/or aluminum oxide (AlO), and the second interlayer insulating layer 152 may be formed of or include low-k dielectric materials, TEOS, silicon carbide hydroxide (SiCHO), and/or silicon oxide (SiO). The third interlayer insulating layer 153 may include an insulating material.

First conductive lines 143 may be provided to extend in (e.g., extend through or penetrate) the first interlayer insulating layer 142 and the first etch stop layer 141. The first conductive lines 143 may be extended in the second direction D2. The first conductive lines 143 may be spaced apart from each other in the first direction D1. The first conductive lines 143 may include a conductive material. As an example, the first conductive lines 143 may be formed of or include Ru, Mo, W, Cu, and/or Co.

A conductive structure 170 may be provided to extend in (e.g., extend through or penetrate) the second etch stop layer 151, the second interlayer insulating layer 152, and the third interlayer insulating layer 153. The conductive structure 170 may include a lower portion 171 and an upper portion 172 on the lower portion 171. The lower portion 171 of the conductive structure 170 may extend in (e.g., extend through or penetrate) the second etch stop layer 151 and the second interlayer insulating layer 152. The upper portion 172 of the conductive structure 170 may extend in (e.g., extend through or penetrate) the third interlayer insulating layer 153. For example, the lower portion 171 of the conductive structure 170 may be defined as a portion of the conductive structure 170 in the second etch stop layer 151 and the second interlayer insulating layer 152. For example, the upper portion 172 of the conductive structure 170 may be defined as a portion of the conductive structure 170 in the third interlayer insulating layer 153. The lower portion 171 of the conductive structure 170 may be at least partially surrounded (e.g., at least partially enclosed) by the second etch stop layer 151 and the second interlayer insulating layer 152. For example, side surfaces of the lower portion 171 of the conductive structure 170 may be surrounded by the second etch stop layer 151 and the second interlayer insulating layer 152. The upper portion 172 of the conductive structure 170 may be at least partially surrounded (e.g., at least partially enclosed) by the third interlayer insulating layer 153. For example, side surfaces of the upper portion 172 of the conductive structure 170 may be surrounded by the third interlayer insulating layer 153. A boundary between the lower and upper portions 171 and 172 of the conductive structure 170 may be located at substantially the same level (in the third direction D3) as an upper (e.g., an uppermost) surface 152_T of the second interlayer insulating layer 152 and a lower (e.g., a lowermost) surface 153_B of the third interlayer insulating layer 153. The lower portion 171 of the conductive structure 170 may be disposed at a level lower than the upper surface 152_T of the second interlayer insulating layer 152 and the lower surface 153_B of the third interlayer insulating layer 153. The upper portion 172 of the conductive structure 170 may be disposed at a level higher than the upper surface 152_T of the second interlayer insulating layer 152 and the lower surface 153_B of the third interlayer insulating layer 153.

A width of the lower portion 171 of the conductive structure 170 (in the first direction D1 and/or the second direction D2) may decrease as a distance to the first conductive lines 143 decreases (in the third direction D3). As an example, a width W1 of the lower portion 171 of the conductive structure 170 in the second direction D2 may decrease as a distance to the first conductive lines 143 decreases (in the third direction D3), and a width W3 of the lower portion 171 of the conductive structure 170 in the first direction D1 may decrease as a distance to the first conductive lines 143 decreases (in the third direction D3). The width of the lower portion 171 of the conductive structure 170 may decrease as a vertical level (of the lower portion 171 of the conductive structure 170) is lowered.

A width of the upper portion 172 of the conductive structure 170 (in the first direction D1 and/or the second direction D2) may increase as a distance to the first conductive lines 143 decreases (in the third direction D3). As an example, a width W2 of the upper portion 172 of the conductive structure 170 in the second direction D2 may increase as a distance to the first conductive lines 143 decreases (in the third direction D3), and a width W4 of the upper portion 172 of the conductive structure 170 in the first direction D1 may increase as a distance to the first conductive lines 143 decreases (in the third direction D3). The width of the upper portion 172 of the conductive structure 170 may increase as a vertical level (of the upper portion 172 of the conductive structure 170) is lowered.

An intervening portion IN of the first interlayer insulating layer 142 is defined between a pair of the first conductive lines 143, which are adjacent to each other in the first direction D1. The intervening portion IN of the first interlayer insulating layer 142 may be in contact with the pair of the first conductive lines 143, which are adjacent to each other in the first direction D1.

A lower (e.g., a lowermost) surface 170_B of the conductive structure 170 may be in contact with upper (e.g., uppermost) surfaces 143_T of the pair of the first conductive lines 143, which are adjacent to each other in the first direction D1, and an upper (e.g., an uppermost) surface IN_T of the intervening portion IN. The upper surfaces 143_T of the pair of the first conductive lines 143, which are adjacent to each other in the first direction D1, may be coplanar with the upper surface IN_T of the intervening portion IN. The upper surfaces 143_T of the pair of the first conductive lines 143, which are adjacent to each other in the first direction D1, may be placed at the same level as the upper surface IN_T of the intervening portion IN (in the third direction D3). The lower surface 170_B of the conductive structure 170 may be flat. The lower surface 170_B of the conductive structure 170 may be a lower (e.g., a lowermost) surface of the lower portion 171 of the conductive structure 170.

A width of the lower surface 170_B of the conductive structure 170 in the first direction D1 may be larger than a sum of widths of the upper surfaces 143_T of the pair (e.g., two) of the first conductive lines 143, which are adjacent to each other in the first direction D1, and a width of the upper surface IN_T of the intervening portion IN (between the pair of the first conductive lines 143) in the first direction D1.

The conductive structure 170 includes a barrier layer 174 and a conductive layer 173 on the barrier layer 174. The barrier layer 174 is in contact with the upper (e.g., the uppermost) surfaces 143_T of the first conductive lines 143, which are adjacent to each other in the first direction D1, and the upper (e.g., the uppermost) surface IN_T of the intervening portion IN. The barrier layer 174 may include a conductive material. As an example, the barrier layer 174 may be formed of or include titanium (Ti), titanium nitride (TiN), tantalum (Ta), tantalum nitride (TaN), and/or transition metal chalcogenides (e.g., MoS and WS). The conductive layer 173 may include a conductive material. As an example, the conductive layer 173 may be formed of or include Ru, Mo, W, Cu, and/or Co.

A second conductive line 160 may be provided to extend in (e.g., extend through or penetrate) the third interlayer insulating layer 153. The second conductive line 160 may be at least partially surrounded (e.g., at least partially enclosed) by the third interlayer insulating layer 153. For example, the third interlayer insulating layer 153 may extend around side surfaces of the second conductive line 160. A lower (e.g., a lowermost) surface 160_B of the second conductive line 160 may be in contact with the upper (e.g., the uppermost) surface 152_T of the second interlayer insulating layer 152. The second conductive line 160 may be disposed at the same level as the upper portion 172 of the conductive structure 170. For example, the second conductive line 160 may overlap the upper portion 172 of the conductive structure 170 in the first direction D1 and/or the second direction D2. The lower (e.g., the lowermost) surface 160_B of the second conductive line 160 may be located at substantially the same level as the boundary between the lower and upper portions 171 and 172 of the conductive structure 170 (in the third direction D3).

A width of the second conductive line 160 (in the first direction D1 and/or the second direction D2) may increase as a distance to the first conductive lines 143 decreases (in the third direction D3). As an example, a width W5 of the second conductive line 160 in the first direction D1 may increase as a distance to the first conductive lines 143 decreases (in the third direction D3). The width of the second conductive line 160 may increase as a vertical level (of the second conductive line 160) is lowered.

The second conductive line 160 may include a line barrier layer 161 and a line conductive layer 162 on the line barrier layer 161. A lower (e.g., a lowermost) surface of the line barrier layer 161 may be the lower (e.g., the lowermost) surface 160_B of the second conductive line 160. A side surface 161_S of the line barrier layer 161 and a side surface 162_S of the line conductive layer 162 may be in contact with a side surface of the third interlayer insulating layer 153. The side surface 161_S of the line barrier layer 161 may be coplanar with the side surface 162_S of the line conductive layer 162. The side surface 161_S of the line barrier layer 161 and the side surface 162_S of the line conductive layer 162 may be inclined at an angle to the upper (e.g., the uppermost) surface 152_T of the second interlayer insulating layer 152 and the lower (e.g., the lowermost) surface 153_B of the third interlayer insulating layer 153. An angle between the side surface 161_S of the line barrier layer 161 and the lower (e.g., the lowermost) surface 153_B of the third interlayer insulating layer 153 may be an obtuse angle at a portion where the side surface 161_S of the line barrier layer 161 is connected to the lower (e.g., the lowermost) surface 153_B of the third interlayer insulating layer 153.

The line barrier layer 161 may include the same conductive material as the barrier layer 174. The line conductive layer 162 may include the same conductive material as the conductive layer 173.

Referring to FIGS. 4D and 4E, the barrier layer 174 may include a lower portion 174a and an upper portion 174b on the lower portion 174a. The conductive layer 173 may include a lower portion 173a and an upper portion 173b on the lower portion 173a. The lower portion 171 of the conductive structure 170 may include the lower portion 174a of the barrier layer 174 and the lower portion 173a of the conductive layer 173. The upper portion 172 of the conductive structure 170 may include the upper portion 174b of the barrier layer 174 and the upper portion 173b of the conductive layer 173. The lower portion 173a of the conductive layer 173 may be at least partially (e.g., at least partially enclosed) by the lower portion 174a of the barrier layer 174. For example, the lower portion 174a of the barrier layer 174 may extend around side surfaces of the lower portion 173a of the conductive layer 173.

An outer side surface 174a_S1 of the lower portion 174a of the barrier layer 174 may be in contact with a side surface of the second interlayer insulating layer 152. For example, the lower portion 174a of the barrier layer 174 may be defined as a portion of the barrier layer 174 in the second interlayer insulating layer 152. An inner side surface 174a_S2 of the lower portion 174a of the barrier layer 174 may be in contact with the lower portion 173a of the conductive layer 173. The outer and inner side surfaces 174a_S1 and 174a_S2 of the lower portion 174a of the barrier layer 174 may be inclined at an angle to the upper (e.g., the uppermost) surface 152_T of the second interlayer insulating layer 152 and the lower (e.g., the lowermost) surface 153_B of the third interlayer insulating layer 153. When viewed in the sectional views of FIG. 4D or 4E, the outer and inner side surfaces 174a_S1 and 174a_S2 of the lower portion 174a of the barrier layer 174 may be extended to be parallel to each other. The lower portion 174a of the barrier layer 174 may have a substantially constant width (in horizontal directions, such as the second direction D2). As an example, a width W7 of the lower portion 174a of the barrier layer 174 in the second direction D2 may be substantially constant (regardless of the level of the lower portion 174a of the barrier layer 174 in the third direction D3). The outer side surface 174a_S1 of the lower portion 174a of the barrier layer 174 may be an outer side surface of the lower portion 171 of the conductive structure 170.

An outer side surface 174b_S1 of the upper portion 174b of the barrier layer 174 may be in contact with the side surface of the third interlayer insulating layer 153. For example, the upper portion 174b of the barrier layer 174 may be defined as a portion of the barrier layer 174 in the third interlayer insulating layer 153. An inner side surface 174b_S2 of the upper portion 174b of the barrier layer 174 may be in contact with the upper portion 173b of the conductive layer 173. The outer and inner side surfaces 174b_S1 and 174b_S2 of the upper portion 174b of the barrier layer 174 may be inclined at an angle to the upper (e.g., the uppermost) surface 152_T of the second interlayer insulating layer 152 and the lower (e.g., the lowermost) surface 153_B of the third interlayer insulating layer 153. For example, the inner side surface 174b_S2 of the upper portion 174b of the barrier layer 174 may be inclined at an angle to an imaginary line extending from the upper (e.g., the uppermost) surface 152_T of the second interlayer insulating layer 152 and/or the lower (e.g., the lowermost) surface 153_B of the third interlayer insulating layer 153 in the second direction D2. When viewed in the sectional views of FIG. 4D or 4E, the outer and inner side surfaces 174b_S1 and 174b_S2 of the upper portion 174b of the barrier layer 174 may be extended in two different directions that are not parallel to each other. A width of the upper portion 174b of the barrier layer 174 (in the first direction D1 and/or the second direction D2) may increase as a distance to the first conductive lines 143 decreases (in the third direction D3). As an example, a width W6 of the upper portion 174b of the barrier layer 174 in the second direction D2 may increase as a distance to the first conductive lines 143 decreases. The width of the upper portion 174b of the barrier layer 174 may increase as a vertical level (of the upper portion 174b of the barrier layer 174) is lowered.

The inner side surface 174a_S2 of the lower portion 174a of the barrier layer 174 may be coplanar with the inner side surface 174b_S2 of the upper portion 174b of the barrier layer 174. When viewed in the sectional views of FIGS. 4D and 4E, the inner side surface 174a_S2 of the lower portion 174a of the barrier layer 174 and the inner side surface 174b_S2 of the upper portion 174b of the barrier layer 174 may be located on (may be formed of) a single straight line.

The outer side surface 174b_S1 of the upper portion 174b of the barrier layer 174 may include a first portion P1. The outer side surface 174a_S1 of the lower portion 174a of the barrier layer 174 may include a second portion P2. The first portion P1 and the second portion P2 may be spaced apart from each other. The upper portion 174b of the barrier layer 174 may include a connection surface 174b_S3 connecting the first portion P1 to the second portion P2. For example, the connection surface 174b_S3 may be between the first portion P1 and the second portion P2 (in the second direction D2). The connection surface 174b_S3 may be in contact with the upper (e.g., the uppermost) surface 152_T of the second interlayer insulating layer 152. For example, the connection surface 174b_S3 may be coplanar with the upper surface 152_T of the second interlayer insulating layer 152 and the lower surface 153_B of the third interlayer insulating layer 153.

The outer side surface 174b_S1 of the upper portion 174b of the barrier layer 174 may include a third portion P3. The outer side surface 174a_S1 of the lower portion 174a of the barrier layer 174 may include a fourth portion P4. The third portion P3 and the fourth portion P4 may be connected to each other. The connecting portion between the third portion P3 and the fourth portion P4 may be at (substantially) the same vertical level of the upper surface 152_T of the second interlayer insulating layer 152 and/or the lower surface 153_B of the third interlayer insulating layer 153.

An upper (e.g., an uppermost) surface 174b_S4 of the upper portion 174b of the barrier layer 174 may connect the inner side surface 174b_S2 of the upper portion 174b of the barrier layer 174 to the outer side surface 174b_S1 of the upper portion 174b of the barrier layer 174. The upper (e.g., the uppermost) surface 174b_S4 of the upper portion 174b of the barrier layer 174 may be between the inner side surface 174b_S2 of the upper portion 174b of the barrier layer 174 and the outer side surface 174b_S1 of the upper portion 174b of the barrier layer 174 in the second direction D2. The upper (e.g., the uppermost) surface 174b_S4 of the upper portion 174b of the barrier layer 174 may be in contact with the upper portion 173b of the conductive layer 173.

The lower portion 173a of the conductive layer 173 may be spaced apart from the second interlayer insulating layer 152 by the lower portion 174a of the barrier layer 174. The upper portion 173b of the conductive layer 173 may be in contact with the third interlayer insulating layer 153. An outer side surface 173b_S1 of the upper portion 173b of the conductive layer 173 may be in contact with the side surface of the third interlayer insulating layer 153.

The outer side surface 173b_S1 of the upper portion 173b of the conductive layer 173 may be coplanar with the outer side surface 174b_S1 of the upper portion 174b of the barrier layer 174. When viewed in the sectional views of FIGS. 4D and 4E, the outer side surface 173b_S1 of the upper portion 173b of the conductive layer 173 and the outer side surface 174b_S1 of the upper portion 174b of the barrier layer 174 may be located on (may be formed of) a single straight line. An outer side surface of the upper portion 172 of the conductive structure 170 may include the outer side surface 174b_S1 of the upper portion 174b of the barrier layer 174 and the outer side surface 173b_S1 of the upper portion 173b of the conductive layer 173.

An angle AN1 between the first portion P1 and the lower (e.g., the lowermost) surface 153_B of the third interlayer insulating layer 153 may be an obtuse angle at a portion where the first portion P1 is connected to the lower (e.g., the lowermost) surface 153_B of the third interlayer insulating layer 153. An angle AN2 between the second portion P2 and the upper (e.g., the uppermost) surface 152_T of the second interlayer insulating layer 152 may be an obtuse angle at a portion where the second portion P2 is connected to the upper (e.g., the uppermost) surface 152_T of the second interlayer insulating layer 152. An angle AN3 between the third portion P3 and the lower (e.g., the lowermost) surface 153_B of the third interlayer insulating layer 153 may be an obtuse angle at a portion where the third portion P3 is connected to the lower (e.g., the lowermost) surface 153_B of the third interlayer insulating layer 153. An angle AN4 between the fourth portion P4 and the upper (e.g., the uppermost) surface 152_T of the second interlayer insulating layer 152 may be an obtuse angle at a portion where the fourth portion P4 is connected to the upper (e.g., the uppermost) surface 152_T of the second interlayer insulating layer 152.

In the semiconductor device according to some embodiments of the inventive concept, the lower (e.g., the lowermost) surface 170_B of the conductive structure 170 may have a substantially flat shape, and thus, the first conductive lines 143 and the intervening portion IN, which are placed below the conductive structure 170, may not be damaged in the process of forming the conductive structure 170.

In the semiconductor device according to some embodiments of the inventive concept, since the lower (e.g., the lowermost) surface 170_B of the conductive structure 170 has a substantially flat shape, the barrier layer 174 may have a constant (a uniform) thickness and the reliability of the barrier layer 174 may be improved.

In the semiconductor device according to some embodiments of the inventive concept, since a pair of the first conductive lines 143 are connected (e.g., electrically connected) to each other through the conductive structure 170, it may be possible to omit additional interconnection structures for electrically connecting the pair of the first conductive lines 143 to each other. As a result, it may be possible to reduce a size of the semiconductor device and increase a degree of freedom in designing the semiconductor device.

In the semiconductor device according to some embodiments of the inventive concept, the largest width of the upper portion 172 of the conductive structure 170 in the first direction D1 may be equal to the largest width of the lower portion 171 of the conductive structure 170 in the first direction D1. Thus, it may be possible to reduce a length of the upper portion 172 of the conductive structure 170 in the first direction D1 and increase a degree of freedom in designing a semiconductor device.

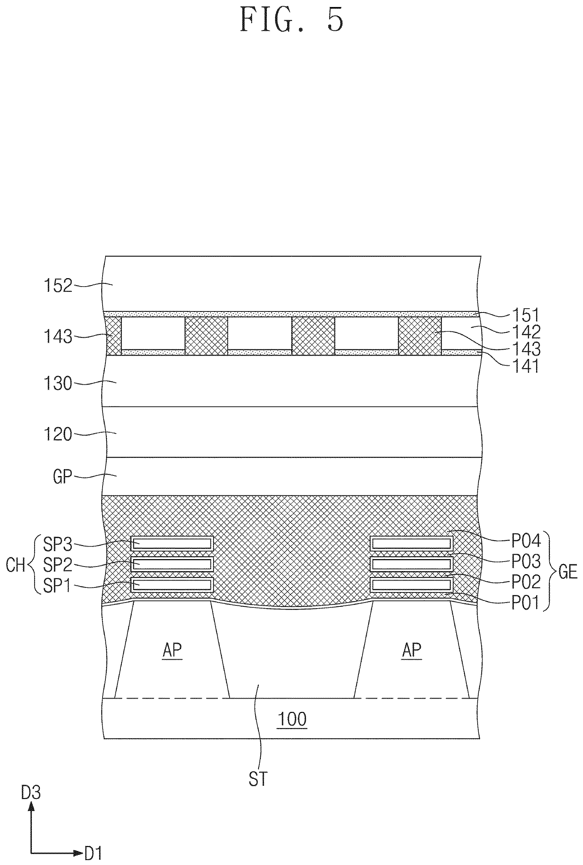

FIGS. 5, 6, 7, 8, 9, and 10 are sectional views illustrating a method of fabricating the semiconductor device of FIGS. 4A to 4E.

Referring to FIG. 5, the active patterns AP may be formed in the substrate 100. The device isolation layer ST may be formed. The channel structures CH, the source/drain patterns SD (e.g., see FIG. 4B), the gate electrodes GE, the gate insulating layers GI (e.g., see FIG. 4B), the gate spacers GS (e.g., see FIG. 4B), the gate capping patterns GP, the first insulating layer 110 (e.g., see FIG. 4B), the second insulating layer 120, and the active contacts AC may be formed.

The cover insulating layer 130 may be formed on the second insulating layer 120. The conductive contact 131 (e.g., see FIG. 4B) may be formed to extend in (e.g., penetrate) the cover insulating layer 130.

The first etch stop layer 141 may be formed on the cover insulating layer 130. The first interlayer insulating layer 142 may be formed on the first etch stop layer 141. The first conductive lines 143 are formed in the first etch stop layer 141 and the first interlayer insulating layer 142. The formation of the first conductive lines 143 may include etching the first interlayer insulating layer 142 and the first etch stop layer 141 and forming the first conductive lines 143 in empty spaces, which are formed by etching the first interlayer insulating layer 142 and the first etch stop layer 141. The first etch stop layer 141 may be used as an etch stop layer in the process of etching the first interlayer insulating layer 142.

The second etch stop layer 151 may be formed on the first interlayer insulating layer 142 and the first conductive lines 143. The second interlayer insulating layer 152 may be formed on the second etch stop layer 151.

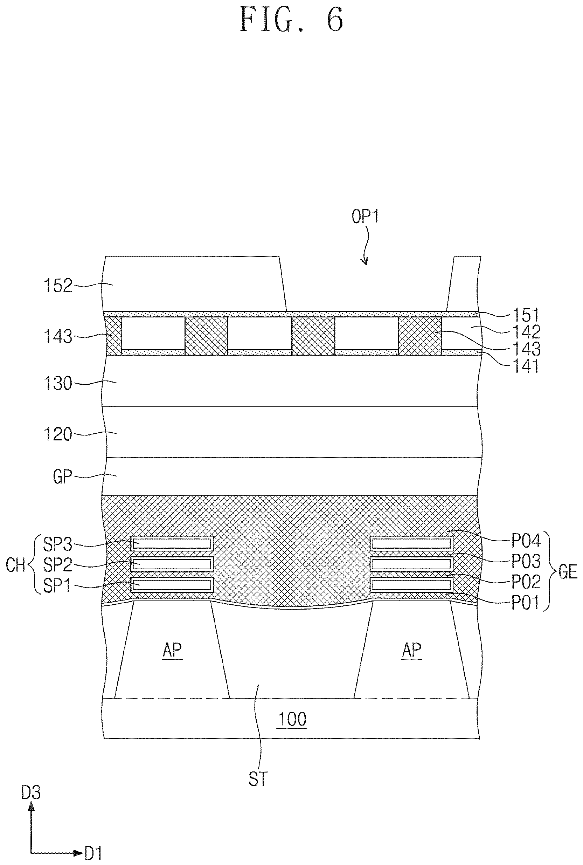

Referring to FIG. 6, a first opening OP1 may be formed to extend in (e.g., extend through or penetrate) the second interlayer insulating layer 152. The first opening OP1 may be formed by etching the second interlayer insulating layer 152. The first opening OP1 may be at least partially surrounded (e.g., at least partially enclosed) by the second interlayer insulating layer 152. The first opening OP1 may be formed to expose at least a portion of an upper (e.g., an uppermost) surface of the second etch stop layer 151. The second etch stop layer 151 may be used as an etch stop layer in a process of forming the first opening OP1. A width of the first opening OP1 in the first direction D1 may decrease as a distance to the first conductive lines 143 decreases (in the third direction D3). The (exposed portion of the) upper (e.g., the uppermost) surface of the second etch stop layer 151 and (exposed) the side surface of the second interlayer insulating layer 152 may define the first opening OP1.

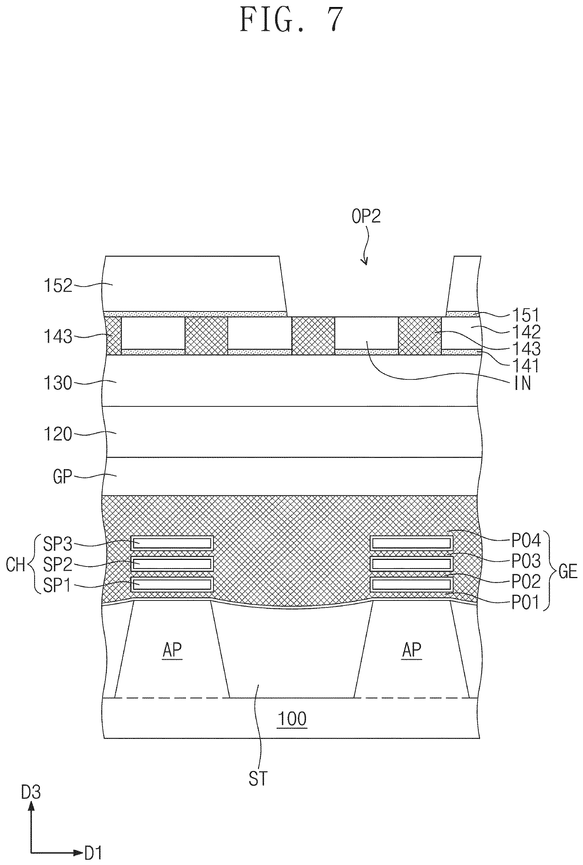

Referring to FIG. 7, the first opening OP1 may be expanded. For example, the first opening OP1 may be expanded by etching (the exposed portion of the upper surface of) the second etch stop layer 151 exposed by the first opening OP1. The (portions of the) first conductive lines 143 and the intervening portion IN of the first interlayer insulating layer 142 may be exposed through the expanded first opening OP1. The expanded first opening OP1 may be referred to as a second opening OP2. An upper (e.g., an uppermost) surface of the first interlayer insulating layer 142, upper (e.g., uppermost) surfaces of the first conductive lines 143, a side surface of the second etch stop layer 151, and the side surface of the second interlayer insulating layer 152 may define the second opening OP2. For example, the second opening OP2 may expose (at least a portion of) the upper (e.g., the uppermost) surface of the first interlayer insulating layer 142 (e.g., the intervening portion IN), the upper (e.g., the uppermost) surfaces of the first conductive lines 143, the side surface of the second etch stop layer 151, and the side surface of the second interlayer insulating layer 152

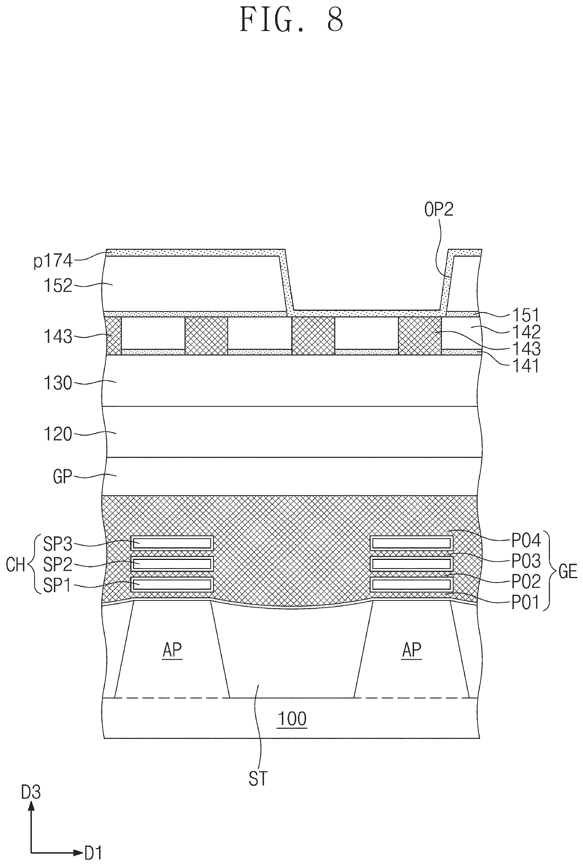

Referring to FIG. 8, a preliminary barrier layer p174 may be formed. The preliminary barrier layer p174 may be conformally formed on an upper (e.g., an uppermost) surface of the second interlayer insulating layer 152, the side surface of the second interlayer insulating layer 152, the upper (e.g., the uppermost) surfaces of the first conductive lines 143, the upper (e.g., the uppermost) surface of the first interlayer insulating layer 142, and the side surface of the second etch stop layer 151. The preliminary barrier layer p174 may be in contact with the upper (e.g., the uppermost) surface of the second interlayer insulating layer 152, the side surface of the second interlayer insulating layer 152, the upper (e.g., the uppermost) surfaces of the first conductive lines 143, the upper (e.g., the uppermost) surface of the first interlayer insulating layer 142, and the side surface of the second etch stop layer 151.

The preliminary barrier layer p174 may include a conductive material. In some embodiments, the preliminary barrier layer p174 may be formed of or include titanium (Ti), titanium nitride (TiN), tantalum (Ta), tantalum nitride (TaN), and/or transition metal chalcogenides (e.g., MoS and WS).

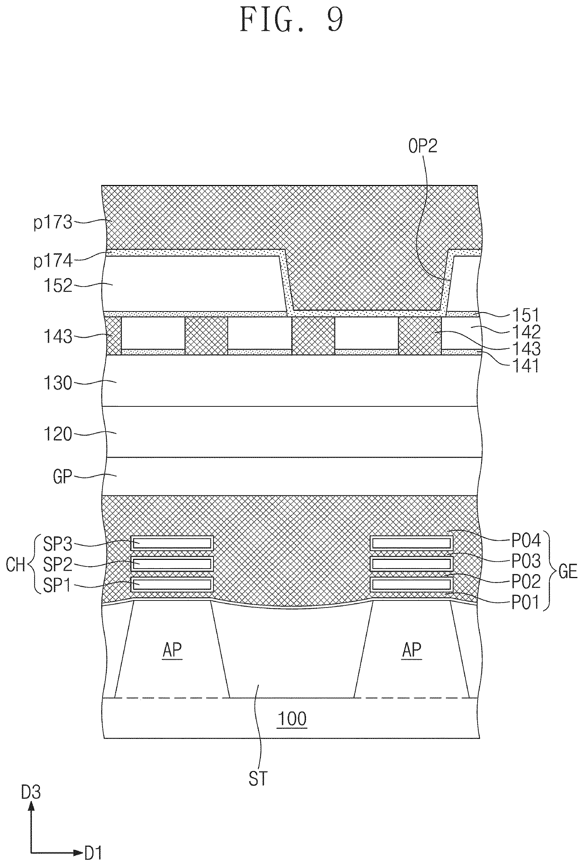

Referring to FIG. 9, a preliminary conductive layer p173 may be formed on the preliminary barrier layer p174. The preliminary conductive layer p173 may include a conductive material. In some embodiment, the preliminary conductive layer p173 may be formed of or include Ru, Mo, W, Cu, and/or Co.

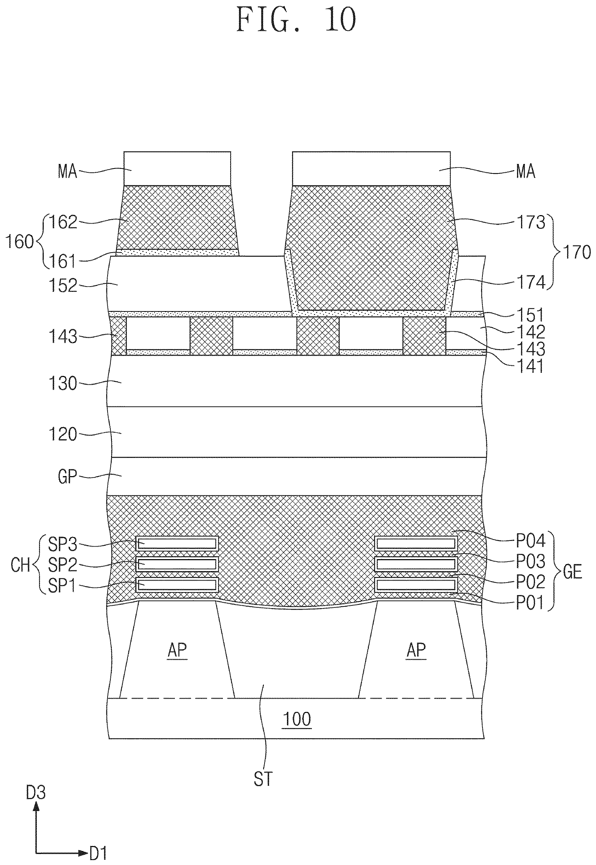

Referring to FIG. 10, a mask layer MA may be formed on the preliminary conductive layer p173. The formation of the mask layer MA may include forming a preliminary mask layer on the preliminary conductive layer p173 and patterning the preliminary mask layer to form the mask layer MA. The mask layer MA may include an insulating material.

The preliminary conductive layer p173 and the preliminary barrier layer p174 may be etched using the mask layer MA as an etch mask. The barrier layer 174 and the line barrier layer 161, which are spaced apart from each other, may be formed as a result of the etching of the preliminary barrier layer p174. The conductive layer 173 and the line conductive layer 162 may be formed as a result of the etching of the preliminary conductive layer p173. The line barrier layer 161 and the line conductive layer 162 may constitute the second conductive line 160. The barrier layer 174 and the conductive layer 173 may constitute the conductive structure 170. The lower portion 171 (e.g., see FIGS. 4B and 4C) of the conductive structure 170 may be disposed in the second opening OP2. The upper portion 172 (e.g., see FIGS. 4B and 4C) of the conductive structure 170 may be disposed at a level higher than the second opening OP2 in the third direction D3.

In some embodiments, the preliminary conductive layer p173 and the preliminary barrier layer p174 may be etched such that a width of the upper portion 172 of the conductive structure 170 (in the first direction D1 and/or the second direction D2) is equal to or larger than a width of the lower portion 171 of the conductive structure 170 (in the first direction D1 and/or the second direction D2).

In some embodiments, when measured in the first direction D1, the largest width (in the first direction D1 and/or the second direction D2) of a portion of the mask layer MA overlapped with the second opening OP2 in the third direction D3 may be smaller than the largest width (in the first direction D1 and/or the second direction D2) of the second opening OP2.

At least a portion of the upper (e.g., the uppermost) surface of the second interlayer insulating layer 152 may be exposed, as a result of the etching of the preliminary conductive layer p173 and the preliminary barrier layer p174.

Referring to FIGS. 4B and 4C, the mask layer MA may be removed. The third interlayer insulating layer 153 may be formed.

In the fabrication method according to some embodiment of the inventive concept, since the first opening OP1 is formed to have a width (in the first direction D1 and/or the second direction D2) larger than (or equal to) (the width of) the first conductive line 143 and (the width of) the lower portion 171 of the conductive structure 170 (in the first direction D1 and/or the second direction D2) is formed in the first opening OP1, it may be possible to reduce a technical difficulty in the process of forming the conductive structure 170.

In the fabrication method according to some embodiments of the inventive concept, since the upper portion 172 of the conductive structure 170 is formed by etching the preliminary conductive layer p173 and the preliminary barrier layer p174, it may be possible to reduce a length of the upper portion 172 of the conductive structure 170.

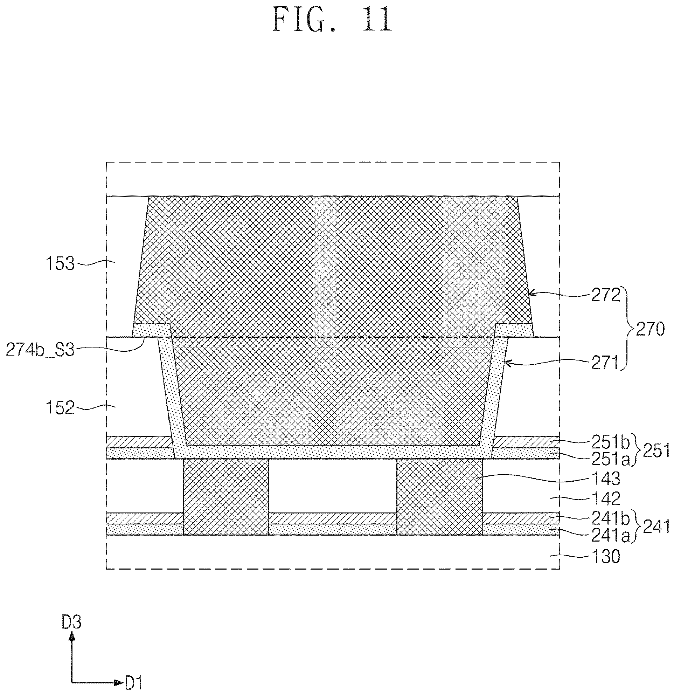

FIG. 11 is an enlarged sectional view illustrating a semiconductor device according to some embodiments of the inventive concept. The semiconductor device of FIG. 11 may be similar to the semiconductor device described with reference to FIGS. 4A to 4E, except for the features to be described below. FIG. 11 may correspond to the portion E3 of FIG. 4C.

Referring to FIG. 11, a first etch stop layer 241 between the cover insulating layer 130 and the first interlayer insulating layer 142 may include a first layer 241a and a second layer 241b. The first layer 241a and the second layer 241b may be formed of or include different insulating materials from each other. In some embodiments, the first etch stop layer 241 may include three or more layers.

A second etch stop layer 251 between the first interlayer insulating layer 142 and the second interlayer insulating layer 152 may include a third layer 251a and a fourth layer 251b. The third layer 251a and the fourth layer 251b may be formed of or include different insulating materials from each other. In some embodiments, the second etch stop layer 251 may include three or more layers.

A connection surface 274b_S3 of an upper portion 272 of a conductive structure 270 may connect an outer side surface of the upper portion 272 of the conductive structure 270 to an outer side surface of a lower portion 271 of the conductive structure 270. For example, the connection surface 274b_S3 of the upper portion 272 of the conductive structure 270 may be between the outer side surface of the upper portion 272 of the conductive structure 270 and the outer side surface of the lower portion 271 of the conductive structure 270 in the first direction D1. The connection surface 274b_S3 of the upper portion 272 of the conductive structure 270 may have a ring shape, when viewed in a plan view.

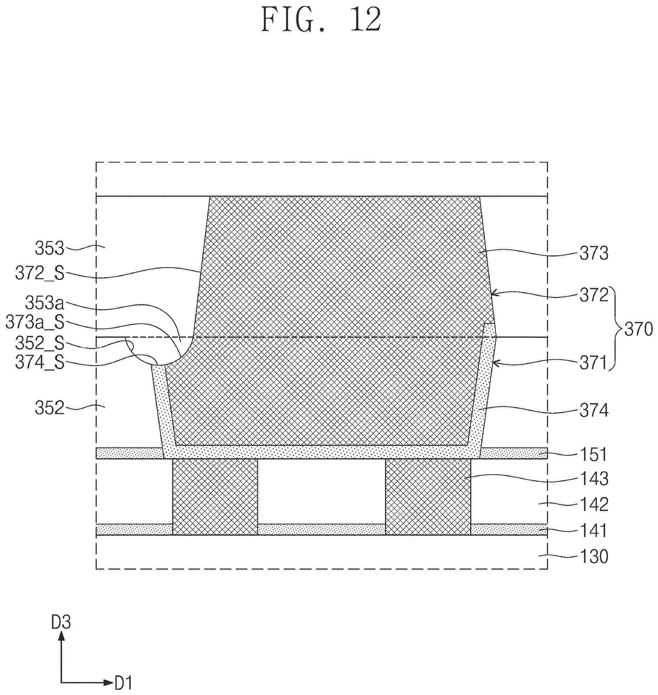

FIG. 12 is an enlarged sectional view illustrating a semiconductor device according to some embodiments of the inventive concept. The semiconductor device of FIG. 12 may be similar to the semiconductor device of FIGS. 4A to 4E, except for the features to be described below. FIG. 12 may correspond to a portion E3 of FIG. 4C.

Referring to FIG. 12, the largest width of an upper portion 372 of a conductive structure 370 in the first direction D1 may be smaller than the largest width of a lower portion 371 of the conductive structure 370 in the first direction D1. A third interlayer insulating layer 353 may include a filling portion 353a, which protrudes toward the lower portion 371 of the conductive structure 370 and a second interlayer insulating layer 352. For example, the third interlayer insulating layer 353 may include the filling portion 353a at least partially extending into the lower portion 371 of the conductive structure 370 and the second interlayer insulating layer 352. The filling portion 353a may be provided at a level lower (in the third direction D3) than the upper portion 372 of the conductive structure 370. The filling portion 353a may be provided between the lower portion 371 of the conductive structure 370 and the second interlayer insulating layer 352.

The second interlayer insulating layer 352 may include a first curved surface 352_S in contact with the filling portion 353a. A barrier layer 374 may include a second curved surface 374_S in contact with the filling portion 353a. A lower portion of a conductive layer 373 may include a third curved surface 373a_S in contact with the filling portion 353a. A bottom surface of the filling portion 353a may have a curved shape. The lower surface of the filling portion 353a may be in contact with the first curved surface 352_S, the second curved surface 374_S, and the third curved surface 373a_S. The third curved surface 373a_S may be connected to an outer side surface 372_S of the upper portion 372 of the conductive structure 370.

As a result of the process of etching the preliminary conductive layer and the preliminary barrier layer, the first curved surface 352_S, the second curved surface 374_S, and the third curved surface 373a_S may be formed. In the process of forming the third interlayer insulating layer 353, an empty space, which is defined by the first curved surface 352_S, the second curved surface 374_S, and the third curved surface 373a_S, may be filled with the filling portion 353a.

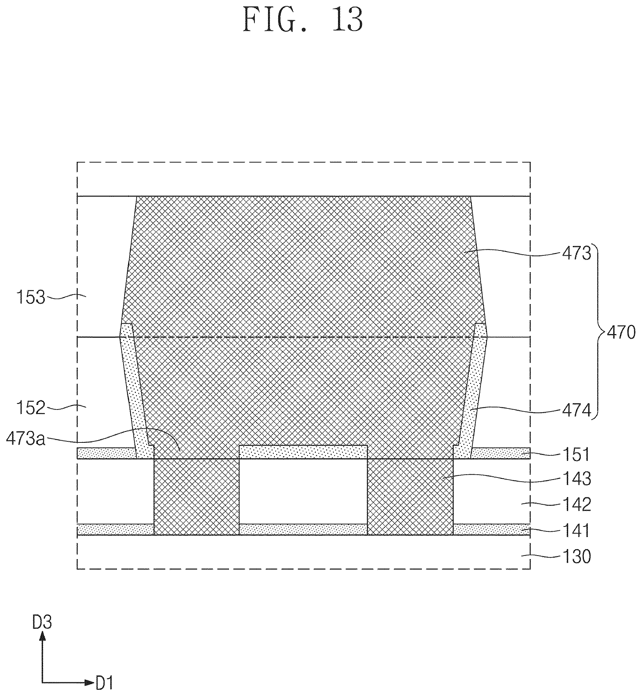

FIG. 13 is an enlarged sectional view illustrating a semiconductor device according to some embodiments of the inventive concept. The semiconductor device of FIG. 13 may be similar to the semiconductor device described with reference to FIGS. 4A to 4E, except for the features to be described below. FIG. 13 may correspond to the portion E3 of FIG. 4C.

Referring to FIG. 13, a conductive layer 473 of a conductive structure 470 may include penetration portions 473a extending in (e.g., extending through or penetrating) a barrier layer 474. The penetration portion 473a may be in contact with the upper (e.g., the uppermost) surface of the first conductive line 143.

The barrier layer 474 may be in contact with the first interlayer insulating layer 142, the second etch stop layer 151, and the second interlayer insulating layer 152. The conductive layer 473 may be spaced apart from the first interlayer insulating layer 142, the second etch stop layer 151, and the second interlayer insulating layer 152 by the barrier layer 474.

Similar to the embodiments of FIG. 8, the preliminary barrier layer may be selectively formed on the first interlayer insulating layer 142, the second etch stop layer 151, and the second interlayer insulating layer 152 in the process of forming the preliminary barrier layer. The preliminary barrier layer may not be formed on the first conductive lines 143. The first conductive lines 143 may be (at least partially) exposed through the preliminary barrier layer.

Similar to the embodiment of FIG. 9, in the process of forming the preliminary conductive layer, the first conductive lines 143, which is exposed through the preliminary barrier layer, may be in contact with the preliminary conductive layer.

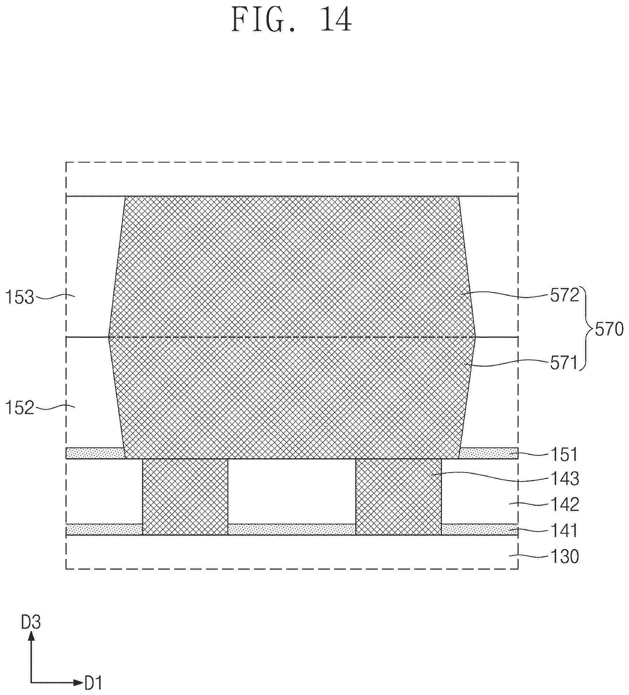

FIG. 14 is an enlarged sectional view illustrating a semiconductor device according to some embodiments of the inventive concept. The semiconductor device of FIG. 14 may be similar to the semiconductor device described with reference to FIGS. 4A to 4E, except for the features to be described below. FIG. 14 may correspond to the portion E3 of FIG. 4C.

Referring to FIG. 14, a conductive structure 570 may not include a barrier layer. The conductive structure 570 may include an upper portion 572 and a lower portion 571, which are connected to each other to form a single object without an interface (a visible interface therebetween). The conductive structure 570 may be formed of or include Ru, Mo, W, Cu, and/or Co.

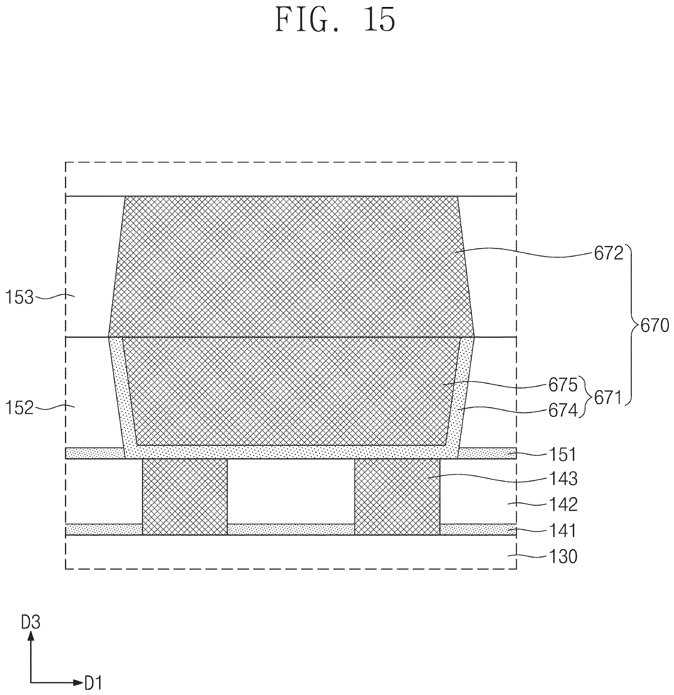

FIG. 15 is an enlarged sectional view illustrating a semiconductor device according to some embodiments of the inventive concept. The semiconductor device of FIG. 15 may be similar to the semiconductor device described with reference to FIGS. 4A to 4E, except for the features to be described below. FIG. 15 may correspond to the portion E3 of FIG. 4C.

Referring to FIG. 15, a lower portion 671 of a conductive structure 670 may include a barrier layer 674 and a first conductive layer 675 in (on) the barrier layer 674. The conductive structure 670 may further include a second conductive layer 672. The second conductive layer 672 may be an upper portion of the conductive structure 670.

The first and second conductive layers 675 and 672 may include different conductive materials from each other. In some embodiments, the first and second conductive layers 675 and 672 may be formed of or include two different materials, respectively, each of which is chosen from the group consisting of Ru, Mo, W, Cu, Co, alloys, or combinations thereof.

An upper (e.g., an uppermost) surface of the barrier layer 674 and an upper (e.g., an uppermost) surface of the first conductive layer 675 may be in contact with a lower (e.g., a lowermost) surface of the second conductive layer 672. The upper (e.g., the uppermost) surface of the barrier layer 674, the upper (e.g., the uppermost) surface of the first conductive layer 675, and the upper (e.g., the uppermost) surface of the second interlayer insulating layer 152 may be coplanar with each other. A lower (e.g., a lowermost) surface of the second conductive layer 672 may be coplanar with a lower (e.g., a lowermost) surface of the third interlayer insulating layer 153. The upper (e.g., the uppermost) surface of the barrier layer 674, the upper (e.g., the uppermost) surface of the first conductive layer 675, the upper (e.g., the uppermost) surface of the second interlayer insulating layer 152, the lower (e.g., the lowermost) surface of the second conductive layer 672, and the lower (e.g., the lowermost) surface of the third interlayer insulating layer 153 may be located at substantially the same level (in the third direction D3).

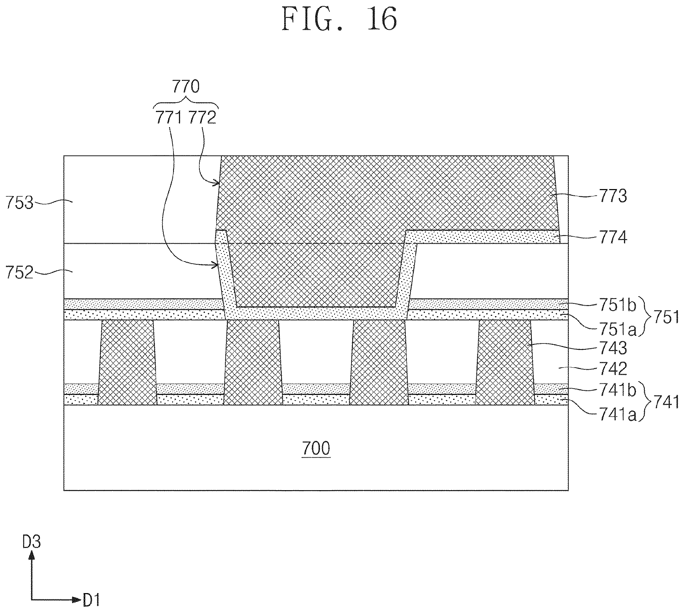

FIG. 16 is a sectional view illustrating a semiconductor device according to some embodiments of the inventive concept.

Referring to FIG. 16, the semiconductor device may include a substrate 700. A first etch stop layer 741 may be provided on the substrate 700. A first interlayer insulating layer 742 may be provided on the first etch stop layer 741.

In some embodiments, an electronic element and an insulating layer on (e.g., covering or overlapping) the electronic element may be provided between the substrate 700 and the first etch stop layer 741. In some embodiments, the electronic element may include a transistor, a capacitor, resistor, and/or a diode. The electronic element may be electrically connected to a conductive line 743, which will be described below.

The first etch stop layer 741 may include a first layer 741a on the substrate 700 and a second layer 741b on the first layer 741a. The first layer 741a and the second layer 741b may be formed of or include different insulating materials from each other. The first interlayer insulating layer 742 may include an insulating material having an etch selectivity with respect to the first etch stop layer 741.

Conductive lines 743 may be provided to extend in (e.g., extend through or penetrate) the first etch stop layer 741 and the first interlayer insulating layer 742. The conductive lines 743 may include a conductive material.

A second etch stop layer 751 may be provided on the first interlayer insulating layer 742. A second interlayer insulating layer 752 may be provided on the second etch stop layer 751. A third interlayer insulating layer 753 may be provided on the second interlayer insulating layer 752.

The second etch stop layer 751 may include a third layer 751a on the first interlayer insulating layer 742 and a fourth layer 751b on the third layer 751a. The third layer 751a and the fourth layer 751b may be formed of or include different insulating materials from each other. The second interlayer insulating layer 752 may include an insulating material having an etch selectivity with respect to the second etch stop layer 751. The third interlayer insulating layer 753 may include an insulating material.

A conductive structure 770 may be provided to extend in (e.g., extend through or penetrate) the second etch stop layer 751, the second interlayer insulating layer 752, and the third interlayer insulating layer 753. The conductive structure 770 may be in contact with the conductive lines 743, which are adjacent to each other. A lower portion 771 of the conductive structure 770 may be (at least partially) surrounded (e.g., at least partially enclosed) by the second etch stop layer 751 and the second interlayer insulating layer 752. For example, the second etch stop layer 751 and the second interlayer insulating layer 752 may extend around side surface of the lower portion 771 of the conductive structure 770. An upper portion 772 of the conductive structure 770 may be (at least partially) surrounded (e.g., at least partially enclosed) by the third interlayer insulating layer 753. For example, the third interlayer insulating layer 753 may extend around side surfaces of the upper portion 772 of the conductive structure 770.

The conductive structure 770 may include a barrier layer 774 and a conductive layer 773 on the barrier layer 774. The barrier layer 774 may be in contact with upper (e.g., uppermost) surfaces of the conductive lines 743, a side surface of the second etch stop layer 751, side and upper (e.g., uppermost) surfaces of the second interlayer insulating layer 752, and a side surface of the third interlayer insulating layer 753. The conductive layer 773 may be spaced apart from the upper (e.g., the uppermost) surfaces of the conductive lines 743, the side surface of the second etch stop layer 751, and the side and upper (e.g., uppermost) surfaces of the second interlayer insulating layer 752 by the barrier layer 774. The conductive layer 773 may be in contact with the side surface of the third interlayer insulating layer 753.

In a semiconductor device according to some embodiments of the inventive concept, a length of an upper portion of a conductive structure may be minimized, and this may increase a degree of freedom in designing a semiconductor device.

In a semiconductor device according to some embodiments of the inventive concept, a lower portion of a conductive structure may be formed through a damascene process, and an upper portion of the conductive structure may be formed through an etching process. Accordingly, it may be possible to reduce a difficulty in a process of forming the conductive structure.

## Claims

1. A semiconductor device, comprising:
first conductive lines (143) that are spaced apart from each other and formed in a first etch stop layer (141) and a first interlayer insulating layer (142);
a conductive structure (170) that is in contact with upper surfaces (143_T) of the first conductive lines (143),
wherein the conductive structure (170) includes a lower portion (171) of the conductive structure (170) and an upper portion (172) of the conductive structure (170),
wherein the lower portion (171) of the conductive structure (170) is in contact with the upper surfaces (143_T) of the first conductive lines (143),
wherein the upper portion (172) of the conductive structure (170) is on the lower portion (171) of the conductive structure (170),
wherein a width (W1) of the lower portion (171) of the conductive structure (170) decreases as a distance between the lower portion (171) of the conductive structure (170) and the upper surfaces (143_T) of the first conductive lines (143) decreases,
wherein a width (W2) of the upper portion (172) of the conductive structure (170) increases as a distance between the upper portion (172) of the conductive structures (170) and the upper surfaces (143_T) of the first conductive lines (143) decreases,
wherein the first interlayer insulating layer (142) includes an intervening portion (IN) between a pair of the first conductive lines (143), which are adjacent to each other in a first direction (D1), and
wherein the lower portion (171) of the conductive structure (170) is in contact with an upper surface (IN_T) of the intervening portion (IN), wherein the conductive structure (170) includes a barrier layer (174) that is in contact with the upper surfaces (143_T) of the first conductive lines (143), which are adjacent to each other in the first direction (D1), and the upper surface (IN_T) of the intervening portion (IN), and
wherein the conductive structure (170) includes a conductive layer (173) on the barrier layer (174).

2. The semiconductor device of claim 1, wherein the barrier layer (174) includes a lower portion (174a) of the barrier layer (174) and an upper portion (174b) of the barrier layer (174),
wherein the lower portion (174a) of the barrier layer (174) is in contact with the upper surfaces (143_T) of the first conductive lines (143),
wherein the upper portion (174b) of the barrier layer (174) is on the lower portion (174a) of the barrier layer (174), and
wherein a width (W6) of the upper portion (174b) of the barrier layer increases as a distance between the upper portion (174b) of the barrier layer (174) and the upper surfaces (143_T) of the first conductive lines (143) decreases.

3. The semiconductor device of claim 2, wherein the conductive layer (173) includes a lower portion (173a) of the conductive layer (173) and an upper portion (173b) of the conductive layer (173),
wherein the lower portion (174a) of the barrier layer (174) extends around the lower portion (173a) of the conductive layer (173),
wherein the upper portion (173b) of the conductive layer (173) is on the lower portion (173a) of the conductive layer (173),
wherein an inner side surface (174b_S2) of the lower portion (174a) of the barrier layer (174) is coplanar with an inner side surface (174b_S2) of the upper portion (174b) of the barrier layer (174), and
wherein an outer side surface (174b_S1) of the upper portion (174b) of the barrier layer (174) is coplanar with an outer side surface (173b_S1) of the upper portion (173b) of the conductive layer (173).

4. The semiconductor device of claim 3, further comprising:
the first interlayer insulating layer (152) that extends around the lower portion (174a) of the barrier layer (174) and the lower portion (173a) of the conductive layer (173); and
a second interlayer insulating layer (153) that extends around the upper portion (174b) of the barrier layer (174) and the upper portion (173b) of the conductive layer (173),
wherein the outer side surface (174b_S1) of the upper portion (174b) of the barrier layer (174) and the outer side surface (173b_S1) of the upper portion (173b) of the conductive layer (173) are in contact with the second interlayer insulating layer (153).

5. The semiconductor device of claim 4, wherein the upper portion (174b) of the barrier layer (174) includes a connection surface (174b_S3) between the outer side surface (174b_S1) of the upper portion (174b) of the barrier layer (174) and an outer side surface (174a_S1) of the lower portion (174a) of the barrier layer (174), and
wherein the connection surface (174b_S3) is in contact with an upper surface of the first interlayer insulating layer (152).

6. The semiconductor device of claim 4, wherein an angle between the outer side surface (174b_S1) of the upper portion (174b) of the barrier layer (174) and a lower surface of the second interlayer insulating layer (153) is an obtuse angle, and
wherein an angle between an outer side surface (174a_S1) of the lower portion (174a) of the barrier layer (174) and an upper surface of the first interlayer insulating layer (152) is an obtuse angle.

7. The semiconductor device of claim 1, further comprising:
the first interlayer insulating layer (152) that extends around the lower portion (171) of the conductive structure (170); and
a second interlayer insulating layer (153) that extends around the upper portion (172) of the conductive structure (170),
wherein an angle between an outer side surface of the lower portion (171) of the conductive structure (170) and an upper surface of the first interlayer insulating layer (152) is an obtuse angle, and
wherein an angle between an outer side surface of the upper portion (172) of the conductive structure (170) and a lower surface of the second interlayer insulating layer (153) is an obtuse angle.

8. The semiconductor device of claim 7, further comprising a second conductive line (160) that is in contact with the upper surface of the first interlayer insulating layer (152),
wherein the second interlayer insulating layer (153) extends around the second conductive line (160), and
wherein a width (W5) of the second conductive line (160) increases as a distance between the second conductive line (160) and the upper surfaces (143_T) of the first conductive lines (143) decreases.

9. A method of fabricating a semiconductor device according to any one of claims 1 to 8, comprising:
forming a first interlayer insulating layer (142);
forming first conductive lines (143) that are spaced apart from each other and extend in the first interlayer insulating layer (142);
forming an etch stop layer (151) on the first interlayer insulating layer (142) and the first conductive lines (143);
forming a second interlayer insulating layer (152) on the etch stop layer (151);
etching the second interlayer insulating layer (152) to form a first opening (OP1);
etching the etch stop layer (151) through the first opening (OP1) to form a second opening (OP2), wherein the second opening (OP2) exposes upper surfaces (143_T) of the first conductive lines (143);
forming a preliminary barrier layer (p174) to be in contact with the upper surfaces (143_T) of the first conductive lines (143), a side surface of the etch stop layer (151), and side and upper surfaces (152_T) of the second interlayer insulating layer (152);
forming a preliminary conductive layer (p173) on the preliminary barrier layer (p174);
forming a mask layer (MA) on the preliminary conductive layer (p173); and
etching the preliminary conductive layer (p173) and the preliminary barrier layer (p174) using the mask layer (MA) as an etch mask.

10. The method of claim 9, wherein the etching of the preliminary conductive layer (p173) and the preliminary barrier layer (p174) includes forming a conductive structure (170),
wherein a lower portion (171) of the conductive structure (170) is in the second opening (OP2),
wherein an upper portion (172) of the conductive structure (170) is farther from the upper surfaces (143_T) of the first conductive lines (143) than the second opening (OP2), and
wherein the method further comprises forming a third interlayer insulating layer (153) to extend around the upper portion (172) of the conductive structure (170).

11. The method of claim 10, wherein a width of the lower portion (171) of the conductive structure (170) decreases as a distance between the lower portion (171) of the conductive structure (170) and the upper surfaces (143_T) of the first conductive lines (143) decreases, and
wherein a width of the upper portion (172) of the conductive structure (170) increases as a distance between the upper portion (172) of the conductive structure (170) and the upper surfaces (143_T) of the first conductive lines (143) decreases.

12. The method of claim 9, wherein the etching of the preliminary conductive layer (p173) and the preliminary barrier layer (p174) includes forming a second conductive line (160) that is in contact with the upper surfaces (152_T) of the second interlayer insulating layer (152).

13. The method of claim 9, wherein the etching of the preliminary conductive layer (p173) and the preliminary barrier layer (p174) includes exposing the upper surfaces (152_T) of the second interlayer insulating layer (152).

14. The method of claim 9, wherein the upper surfaces (143_T) of the first conductive lines (143) are coplanar with the upper surface (IN_T) of the intervening portion (IN).

## Patentansprüche

1. Halbleiterbauelement, aufweisend:
erste Leiterbahnen (143), die voneinander beabstandet sind und in einer ersten Ätzstoppschicht (141) sowie einer ersten Zwischenschicht-Isolierschicht (142) ausgebildet sind;
eine leitfähige Struktur (170), die mit oberen Oberflächen (143_T) der ersten Leiterbahnen (143) in Kontakt steht,
wobei die leitfähige Struktur (170) einen unteren Abschnitt (171) der leitfähigen Struktur (170) und einen oberen Abschnitt (172) der leitfähigen Struktur (170) umfasst,
wobei der untere Abschnitt (171) der leitfähigen Struktur (170) mit den oberen Oberflächen (143_T) der ersten Leiterbahnen (143) in Kontakt steht,
wobei sich der obere Abschnitt (172) der leitfähigen Struktur (170) auf dem unteren Abschnitt (171) der leitfähigen Struktur (170) befindet,
wobei eine Breite (W1) des unteren Abschnitts (171) der leitfähigen Struktur (170) mit abnehmendem Abstand zwischen dem unteren Abschnitt (171) der leitfähigen Struktur (170) und den oberen Oberflächen (143_T) der ersten Leiterbahnen (143) abnimmt,
wobei eine Breite (W2) des oberen Abschnitts (172) der leitfähigen Struktur (170) mit abnehmendem Abstand zwischen dem oberen Abschnitt (172) der leitfähigen Strukturen (170) und den oberen Oberflächen (143_T) der ersten Leiterbahnen (143) zunimmt,
wobei die erste Zwischenschicht-Isolierschicht (142) einen dazwischenliegenden Abschnitt (IN) zwischen einem Paar der ersten Leiterbahnen (143) umfasst, die in einer ersten Richtung (D1) nebeneinander liegen, und
wobei der untere Abschnitt (171) der leitfähigen Struktur (170) mit einer oberen Oberfläche (IN_T) des dazwischenliegenden Abschnitts (IN) in Kontakt steht, wobei die leitfähige Struktur (170) eine Sperrschicht (174) umfasst, die mit den oberen Oberflächen (143_T) der ersten Leiterbahnen (143), die in der ersten Richtung (D1) nebeneinander liegen, sowie mit der oberen Oberfläche (IN_T) des dazwischenliegenden Abschnitts (IN) in Kontakt steht, und
wobei die leitfähige Struktur (170) eine leitfähige Schicht (173) auf der Sperrschicht (174) umfasst.

2. Halbleiterbauelement nach Anspruch 1, wobei die Sperrschicht (174) einen unteren Abschnitt (174a) der Sperrschicht (174) und einen oberen Abschnitt (174b) der Sperrschicht (174) umfasst,
wobei der untere Abschnitt (174a) der Sperrschicht (174) mit den oberen Oberflächen (143_T) der ersten Leiterbahnen (143) in Kontakt steht,
wobei sich der obere Abschnitt (174b) der Sperrschicht (174) auf dem unteren Abschnitt (174a) der Sperrschicht (174) befindet, und
wobei eine Breite (W6) des oberen Abschnitts (174b) der Sperrschicht mit abnehmendem Abstand zwischen dem oberen Abschnitt (174b) der Sperrschicht (174) und den oberen Oberflächen (143_T) der ersten Leiterbahnen (143) zunimmt.

3. Halbleiterbauelement nach Anspruch 2, wobei die leitfähige Schicht (173) einen unteren Abschnitt (173a) der leitfähigen Schicht (173) und einen oberen Abschnitt (173b) der leitfähigen Schicht (173) umfasst,
wobei sich der untere Abschnitt (174a) der Sperrschicht (174) um den unteren Abschnitt (173a) der leitfähigen Schicht (173) herum erstreckt,
wobei sich der obere Abschnitt (173b) der leitfähigen Schicht (173) auf dem unteren Abschnitt (173a) der leitfähigen Schicht (173) befindet,
wobei eine innere Seitenfläche (174b_S2) des unteren Abschnitts (174a) der Sperrschicht (174) koplanar mit einer inneren Seitenoberfläche (174b_S2) des oberen Abschnitts (174b) der Sperrschicht (174) ist, und
wobei eine äußere Seitenfläche (174b_S1) des oberen Abschnitts (174b) der Sperrschicht (174) koplanar zu einer äußeren Seitenfläche (173b_S1) des oberen Abschnitts (173b) der leitfähigen Schicht (173) ist.

4. Halbleiterbauelement nach Anspruch 3, ferner aufweisend:
die erste Zwischenschicht-Isolierschicht (152), die sich um den unteren Abschnitt (174a) der Sperrschicht (174) und den unteren Abschnitt (173a) der leitfähigen Schicht (173) herum erstreckt; sowie
eine zweite Zwischenschicht-Isolierschicht (153), die sich um den oberen Abschnitt (174b) der Sperrschicht (174) und den oberen Abschnitt (173b) der leitfähigen Schicht (173) herum erstreckt,
wobei die äußere Seitenfläche (174b_S1) des oberen Abschnitts (174b) der Sperrschicht (174) und die äußere Seitenfläche (173b_S1) des oberen Abschnitts (173b) der leitfähigen Schicht (173) mit der zweiten Zwischenschicht-Isolierschicht (153) in Kontakt stehen.

5. Halbleiterbauelement nach Anspruch 4, wobei der obere Abschnitt (174b) der Sperrschicht (174) eine Verbindungsfläche (174b_S3) zwischen der äußeren Seitenfläche (174b_S1) des oberen Abschnitts (174b) der Sperrschicht (174) und einer äußeren Seitenfläche (174a_S1) des unteren Abschnitts (174a) der Sperrschicht (174) aufweist, und
wobei die Verbindungsfläche (174b_S3) mit einer oberen Oberfläche der ersten Zwischenschicht-Isolierschicht (152) in Kontakt steht.

6. Halbleiterbauelement nach Anspruch 4, wobei ein Winkel zwischen der äußeren Seitenfläche (174b_S1) des oberen Abschnitts (174b) der Sperrschicht (174) und einer unteren Oberfläche der zweiten Zwischenschicht-Isolierschicht (153) ein stumpfer Winkel ist, und
wobei ein Winkel zwischen einer äußeren Seitenfläche (174a_S1) des unteren Abschnitts (174a) der Sperrschicht (174) und einer oberen Oberfläche der ersten Zwischenschicht-Isolierschicht (152) ein stumpfer Winkel ist.

7. Halbleiterbauelement nach Anspruch 1, ferner aufweisend:
die erste Zwischenschicht-Isolierschicht (152), die sich um den unteren Abschnitt (171) der leitfähigen Struktur (170) herum erstreckt; sowie
eine zweite Zwischenschicht-Isolierschicht (153), die sich um den oberen Abschnitt (172) der leitfähigen Struktur (170) herum erstreckt,
wobei ein Winkel zwischen einer äußeren Seitenfläche des unteren Abschnitts (171) der leitfähigen Struktur (170) und einer oberen Oberfläche der ersten Zwischenschicht-Isolierschicht (152) ein stumpfer Winkel ist, und
wobei ein Winkel zwischen einer äußeren Seitenfläche des oberen Abschnitts (172) der leitfähigen Struktur (170) und einer unteren Oberfläche der zweiten Zwischenschicht-Isolierschicht (153) ein stumpfer Winkel ist.

8. Halbleiterbauelement nach Anspruch 7, ferner aufweisend eine zweite Leiterbahn (160), die mit der oberen Oberfläche der ersten Zwischenschicht-Isolierschicht (152) in Kontakt steht,
wobei sich die zweite Zwischenschicht-Isolierschicht (153) um die zweite Leiterbahn (160) herum erstreckt, und
wobei eine Breite (W5) der zweiten Leiterbahn (160) mit abnehmendem Abstand zwischen der zweiten Leiterbahn (160) und den oberen Oberflächen (143_T) der ersten Leiterbahnen (143) zunimmt.

9. Verfahren zur Herstellung eines Halbleiterbauelements nach einem der Ansprüche 1 bis 8, umfassend:
Bilden einer ersten Zwischenschicht-Isolierschicht (142);
Bilden erster Leiterbahnen (143), die voneinander beabstandet sind und sich in der ersten Zwischenschicht-Isolierschicht (142) erstrecken;
Bilden einer Ätzstoppschicht (151) auf der ersten Zwischenschicht-Isolierschicht (142) und den ersten Leiterbahnen (143);
Bilden einer zweiten Zwischenschicht-Isolierschicht (152) auf der Ätzstoppschicht (151);
Ätzen der zweiten Zwischenschicht-Isolierschicht (152), um eine erste Öffnung (OP1) zu bilden;
Ätzen der Ätzstoppschicht (151) durch die erste Öffnung (OP1), um eine zweite Öffnung (OP2) zu bilden, wobei die zweite Öffnung (OP2) die oberen Oberflächen (143_T) der ersten Leiterbahnen (143) freilegt;
Bilden einer vorläufigen Sperrschicht (p174), die mit den oberen Oberflächen (143_T) der ersten Leiterbahnen (143), einer Seitenfläche der Ätzstoppschicht (151) sowie Seitenflächen und oberen Oberflächen (152_T) der zweiten Zwischenschicht-Isolierschicht (152) in Kontakt stehen soll;
Bilden einer vorläufigen leitfähigen Schicht (p173) auf der vorläufigen Sperrschicht (p174);
Bilden einer Maskenschicht (MA) auf der vorläufigen leitfähigen Schicht (p173); und
Ätzen der vorläufigen leitfähigen Schicht (p173) und der vorläufigen Sperrschicht (p174) unter Verwendung der Maskenschicht (MA) als eine Ätzmaske.

10. Verfahren nach Anspruch 9, wobei das Ätzen der vorläufigen leitfähigen Schicht (p173) und der vorläufigen Sperrschicht (p174) ein Bilden einer leitfähigen Struktur (170) umfasst,
wobei sich ein unterer Abschnitt (171) der leitfähigen Struktur (170) in der zweiten Öffnung (OP2) befindet,
wobei ein oberer Abschnitt (172) der leitfähigen Struktur (170) weiter von den oberen Oberflächen (143_T) der ersten Leiterbahnen (143) entfernt ist als die zweite Öffnung (OP2), und
wobei das Verfahren ferner ein Bilden einer dritten Zwischenschicht-Isolierschicht (153) umfasst, die sich um den oberen Abschnitt (172) der leitfähigen Struktur (170) herum erstrecken soll.

11. Verfahren nach Anspruch 10, wobei eine Breite des unteren Abschnitts (171) der leitfähigen Struktur (170) mit abnehmendem Abstand zwischen dem unteren Abschnitt (171) der leitfähigen Struktur (170) und den oberen Oberflächen (143_T) der ersten Leiterbahnen (143) abnimmt, und
wobei eine Breite des oberen Abschnitts (172) der leitfähigen Struktur (170) mit abnehmendem Abstand zwischen dem oberen Abschnitt (172) der leitfähigen Struktur (170) und den oberen Oberflächen (143_T) der ersten Leiterbahnen (143) zunimmt.

12. Verfahren nach Anspruch 9, wobei das Ätzen der vorläufigen leitfähigen Schicht (p173) und der vorläufigen Sperrschicht (p174) ein Bilden einer zweiten Leiterbahn (160) umfasst, die mit den oberen Oberflächen (152_T) der zweiten Zwischenschicht-Isolierschicht (152) in Kontakt steht.

13. Verfahren nach Anspruch 9, wobei das Ätzen der vorläufigen leitfähigen Schicht (p173) und der vorläufigen Sperrschicht (p174) ein Freilegen der oberen Oberflächen (152_T) der zweiten Zwischenschicht-Isolierschicht (152) umfasst.

14. Verfahren nach Anspruch 9, wobei die oberen Oberflächen (143_T) der ersten Leiterbahnen (143) koplanar mit der oberen Oberfläche (IN_T) des dazwischenliegen Abschnitts (IN) sind.

## Revendications

1. Dispositif à semi-conducteur, comprenant :
des premières lignes conductrices (143) qui sont espacées les unes des autres et formées dans une première couche d'arrêt de gravure (141) et une première couche isolante intercouche (142) ;
une structure conductrice (170) qui est en contact avec des surfaces supérieures (143_T) des premières lignes conductrices (143),
dans lequel la structure conductrice (170) comprend une partie inférieure (171) de la structure conductrice (170) et une partie supérieure (172) de la structure conductrice (170),
dans lequel la partie inférieure (171) de la structure conductrice (170) est en contact avec les surfaces supérieures (143_T) des premières lignes conductrices (143),
dans lequel la partie supérieure (172) de la structure conductrice (170) se trouve sur la partie inférieure (171) de la structure conductrice (170),
dans lequel une largeur (W1) de la partie inférieure (171) de la structure conductrice (170) diminue à mesure qu'une distance entre la partie inférieure (171) de la structure conductrice (170) et les surfaces supérieures (143_T) des premières lignes conductrices (143) diminue,
dans lequel une largeur (W2) de la partie supérieure (172) de la structure conductrice (170) augmente à mesure qu'une distance entre la partie supérieure (172) des structures conductrices (170) et les surfaces supérieures (143_T) des premières lignes conductrices (143) diminue,
dans lequel la première couche isolante intercouche (142) comprend une partie intermédiaire (IN) entre une paire des premières lignes conductrices (143), qui sont adjacentes l'une à l'autre dans une première direction (D1), et
dans lequel la partie inférieure (171) de la structure conductrice (170) est en contact avec une surface supérieure (IN_T) de la partie intermédiaire (IN), dans lequel la structure conductrice (170) comprend une couche barrière (174) qui est en contact avec les surfaces supérieures (143_T) des premières lignes conductrices (143), qui sont adjacentes l'une à l'autre dans la première direction (D1), et avec la surface supérieure (IN_T) de la partie intermédiaire (IN), et
dans lequel la structure conductrice (170) comprend une couche conductrice (173) sur la couche barrière (174).

2. Dispositif à semi-conducteur selon la revendication 1, dans lequel la couche barrière (174) comprend une partie inférieure (174a) de la couche barrière (174) et une partie supérieure (174b) de la couche barrière (174),
dans lequel la partie inférieure (174a) de la couche barrière (174) est en contact avec les surfaces supérieures (143_T) des premières lignes conductrices (143),
dans lequel la partie supérieure (174b) de la couche barrière (174) se trouve sur la partie inférieure (174a) de la couche barrière (174), et
dans lequel une largeur (W6) de la partie supérieure (174b) de la couche barrière augmente à mesure qu'une distance entre la partie supérieure (174b) de la couche barrière (174) et les surfaces supérieures (143_T) des premières lignes conductrices (143) diminue.

3. Dispositif à semi-conducteur selon la revendication 2, dans lequel la couche conductrice (173) comprend une partie inférieure (173a) de la couche conductrice (173) et une partie supérieure (173b) de la couche conductrice (173),
dans lequel la partie inférieure (174a) de la couche barrière (174) s'étend autour de la partie inférieure (173a) de la couche conductrice (173),
dans lequel la partie supérieure (173b) de la couche conductrice (173) se trouve sur la partie inférieure (173a) de la couche conductrice (173),
dans lequel une surface latérale intérieure (174b_S2) de la partie inférieure (174a) de la couche barrière (174) est coplanaire avec une surface latérale intérieure (174b_S2) de la partie supérieure (174b) de la couche barrière (174), et
dans lequel une surface latérale extérieure (174b_S1) de la partie supérieure (174b) de la couche barrière (174) est coplanaire avec une surface latérale extérieure (173b_S1) de la partie supérieure (173b) de la couche conductrice (173).

4. Dispositif à semi-conducteur selon la revendication 3, comprenant en outre :
la première couche isolante intercouche (152), qui s'étend autour de la partie inférieure (174a) de la couche barrière (174) et de la partie inférieure (173a) de la couche conductrice (173) ; et
une deuxième couche isolante intercouche (153), qui s'étend autour de la partie supérieure (174b) de la couche barrière (174) et de la partie supérieure (173b) de la couche conductrice (173),
dans lequel la surface latérale extérieure (174b_S1) de la partie supérieure (174b) de la couche barrière (174) et la surface latérale extérieure (173b_S1) de la partie supérieure (173b) de la couche conductrice (173) sont en contact avec la deuxième couche isolante intercouche (153).

5. Dispositif à semi-conducteur selon la revendication 4, dans lequel la partie supérieure (174b) de la couche barrière (174) comprend une surface de raccordement (174b_S3) entre la surface latérale extérieure (174b_S1) de la partie supérieure (174b) de la couche barrière (174) et une surface latérale extérieure (174a_S1) de la partie inférieure (174a) de la couche barrière (174), et
dans lequel la surface de raccordement (174b_S3) est en contact avec une surface supérieure de la première couche isolante intercouche (152).

6. Dispositif à semi-conducteur selon la revendication 4, dans lequel un angle entre la surface latérale extérieure (174b_S1) de la partie supérieure (174b) de la couche barrière (174) et une surface inférieure de la deuxième couche isolante intercouche (153) est un angle obtus, et
dans lequel un angle entre une surface latérale extérieure (174a_S1) de la partie inférieure (174a) de la couche barrière (174) et une surface supérieure de la première couche isolante intercouche (152) est un angle obtus.

7. Dispositif à semi-conducteur selon la revendication 1, comprenant en outre :
la première couche isolante intercouche (152), qui s'étend autour de la partie inférieure (171) de la structure conductrice (170) ; et
une deuxième couche isolante intercouche (153), qui s'étend autour de la partie supérieure (172) de la structure conductrice (170),
dans lequel un angle entre une surface latérale extérieure de la partie inférieure (171) de la structure conductrice (170) et une surface supérieure de la première couche isolante intercouche (152) est un angle obtus, et
dans lequel un angle entre une surface latérale extérieure de la partie supérieure (172) de la structure conductrice (170) et une surface inférieure de la deuxième couche isolante intercouche (153) est un angle obtus.

8. Dispositif à semi-conducteur selon la revendication 7, comprenant en outre une deuxième ligne conductrice (160) qui est en contact avec la surface supérieure de la première couche isolante intercouche (152),
dans lequel la deuxième couche isolante intercouche (153) s'étend autour de la deuxième ligne conductrice (160), et
dans lequel une largeur (W5) de la deuxième ligne conductrice (160) augmente à mesure qu'une distance entre la deuxième ligne conductrice (160) et les surfaces supérieures (143_T) des premières lignes conductrices (143) diminue.

9. Procédé de fabrication d'un dispositif à semi-conducteur selon l'une quelconque des revendications 1 à 8, comprenant les étapes suivantes:
former une première couche isolante intercouche (142) ;
former des premières lignes conductrices (143) qui sont espacées les unes des autres et s'étendent dans la première couche isolante intercouche (142) ;
former une couche d'arrêt de gravure (151) sur la première couche isolante intercouche (142) et les premières lignes conductrices (143) ;
former une deuxième couche isolante intercouche (152) sur la couche d'arrêt de gravure (151) ;
graver la deuxième couche isolante intercouche (152) pour former une première ouverture (OP1) ;
graver la couche d'arrêt de gravure (151) à travers la première ouverture (OP1) pour former une deuxième ouverture (OP2), la deuxième ouverture (OP2) exposant des surfaces supérieures (143_T) des premières lignes conductrices (143) ;
former une couche barrière préliminaire (p174) de manière qu'elle soit en contact avec les surfaces supérieures (143_T) des premières lignes conductrices (143), une surface latérale de la couche d'arrêt de gravure (151), ainsi que des surfaces latérales et supérieures (152_T) de la deuxième couche isolante intercouche (152) ;
former une couche conductrice préliminaire (p173) sur la couche barrière préliminaire (p174) ;
former une couche de masque (MA) sur la couche conductrice préliminaire (p173) ; et
graver la couche conductrice préliminaire (p173) et la couche barrière préliminaire (p174) en utilisant la couche de masque (MA) en tant que masque de gravure.

10. Procédé selon la revendication 9, dans lequel la gravure de la couche conductrice préliminaire (p173) et de la couche barrière préliminaire (p174) comprend la formation d'une structure conductrice (170),
dans lequel une partie inférieure (171) de la structure conductrice (170) se trouve dans la deuxième ouverture (OP2),
dans lequel une partie supérieure (172) de la structure conductrice (170) est plus éloignée des surfaces supérieures (143_T) des premières lignes conductrices (143) que ne l'est la deuxième ouverture (OP2), et
dans lequel le procédé comprend en outre la formation d'une troisième couche isolante intercouche (153) de manière qu'elle s'étende autour de la partie supérieure (172) de la structure conductrice (170).

11. Procédé selon la revendication 10, dans lequel une largeur de la partie inférieure (171) de la structure conductrice (170) diminue à mesure qu'une distance entre la partie inférieure (171) de la structure conductrice (170) et les surfaces supérieures (143_T) des premières lignes conductrices (143) diminue, et
dans lequel une largeur de la partie supérieure (172) de la structure conductrice (170) augmente à mesure qu'une distance entre la partie supérieure (172) de la structure conductrice (170) et les surfaces supérieures (143_T) des premières lignes conductrices (143) diminue.

12. Procédé selon la revendication 9, dans lequel la gravure de la couche conductrice préliminaire (p173) et de la couche barrière préliminaire (p174) comprend la formation d'une deuxième ligne conductrice (160) qui est en contact avec les surfaces supérieures (152_T) de la deuxième couche isolante intercouche (152).

13. Procédé selon la revendication 9, dans lequel la gravure de la couche conductrice préliminaire (p173) et de la couche barrière préliminaire (p174) comprend l'exposition des surfaces supérieures (152_T) de la deuxième couche isolante intercouche (152).

14. Procédé selon la revendication 9, dans lequel les surfaces supérieures (143_T) des premières lignes conductrices (143) sont coplanaires avec la surface supérieure (IN_T) de la partie intermédiaire (IN).
